# EUROPEAN PATENT APPLICATION

(11) **EP 3 735 104 A1**
(43) Date of publication of application: **04.11.2020**
(21) Application number: 18897596.5
(22) Date of filing: 28.12.2018
(51) Int. Cl.: H05B 3/14, H01L 35/30, H01L 35/32, H02N 3/00

(54) **HEAT-GENERATING DEVICE AND USE THEREOF**

(30) Priority: 28.12.2017 JP 2017254563
(71) Applicant: International Engineered Environmental Solutions Inc., Fukuoka-shi, Fukuoka 812-0038 (JP)
(72) Inventor: YAMAMOTO Hiroaki, Fukuoka-shi, Fukuoka 812-0038 (JP)
(74) Representative: HGF
(86) International application number: PCT/JP2018/048611
(87) International publication number: WO 2019/132041

(57) **Abstract**

Provided are a heat generating device capable of efficiently maintaining heat generation for a long time at low cost while saving power, and the use thereof.

The heat generating device includes a hollow container the inside of which is electrically insulated, a pair of opposed electrodes which are housed in the container and which are separately opposed to each other, and a heat generating body which is housed between the opposed electrodes in the container and which contains silicon powder and carbon powder in a mixed state. The heat generating body is configured to have a density of 0.85 g/cm³ to 1.30 g/cm³.

## Description

### Technical Field

The present invention relates to a heat generating device that generates heat upon application of voltage thereto, and particularly, relates to a heat generating device capable of continuously efficiently generating heat for a long time at low cost while saving power, and use of the heat generating device.

### Background Art

Heat generating devices have been widely used not only for electric pots and but also for various heaters including oil heaters and ceramic heaters, and thus, are important and indispensable to modern life.

Meanwhile, in order to boil water in an electric pot, for example, a heat generating device requires electric power of several hundreds of watts to 1 kilowatt as a heat source. Further, in order to maintain the warm state, continuous electric power is also required. Moreover, for example, an oil heater has low usability because the casing thereof is large, and also has high electric power consumption, so that difficulty in frequent use is a weak point.

In view of the aforementioned circumstances, a heat generating device capable of causing a temperature rise in a short time while saving power has been demanded.

For example, as a conventional heat generating device, there has been a heating device including a plurality of glass tubes, resistors provided so as to surround the glass tubes, and a vapor generating unit that generates vapors in order to introduce the vapors into the glass tubes by heating water with use of heat of the resistors generated with electricity caused to flow through the resistors (see Patent Literature 1). Also, for example, as a conventional heat generating device, there has been a fluid temperature increasing filter which is just for increasing the temperature of a fluid but contains silicon and silicon carbide, and is used by being heated by microwaves (see Patent Literature 2).

Meanwhile, a power generating apparatus of generating power by using heat from a heat source has been recently proposed in the heat generation-related field. As a heat source therefor, various ones including a heat source efficiently using exhaust heat from exhaust gas have been considered. This technique has attracted attention also from the viewpoint of efficient use of energy.

Environmental issues recently attract high interest, similarly from the viewpoint of efficient use of energy. In particular, interest in natural energy such as water power, wind power, and sunlight, is increasing. Under the present circumstances, power generation using such natural energy is unstable because the amount of generated power is low. However, efficient use thereof has been demanded.

Therefore, if a heat source using natural energy can be used as a heat source for the power generating apparatus, an excellent power generating apparatus having a high utility value is expected to be obtained also from the viewpoint of efficient use of natural energy.

For example, as a conventional power generating apparatus, an apparatus has been known which is assumed to use exhaust heat discharged from an automobile engine, a factory furnace, or the like, and generates power by using the temperature difference between low temperature and high temperature of the exhaust heat, etc., and by using a thermoelectric conversion module (see Patent Literature 3, for example).

### Citation List

### Patent Literature

Patent Literature 1: Japanese Patent Laid-Open No. 2015-222648
Patent Literature 2: Japanese Patent Laid-Open No. 2011-236070
Patent Literature 3: Japanese Patent Laid-Open No. 2009-194299

### Summary of Invention

### Technical Problem

However, the conventional heat generating devices include a device such as that of Patent Literature 1 that generates vapors by heating water with use of the heat of the resistors generated by electricity caused to flow therethrough. However, since the heat of the resistors is once converted into vapors, thermal energy loss is generated with the conversion. Thus, the amount of actually usable thermal energy is small with respect to the entire generated energy so that the efficiency is low.

In addition, some conventional heat generating devices include a filter such as that of Patent Literature 2 that is used by being heated with microwaves, etc. However, as a prerequisite, high energy is required in order to perform the heating. Thus, the energy efficiency is low. Also, since the filter is limited to use for increasing the temperature of a fluid, the applicability thereof is low from the viewpoint of utility for various uses.

As described above, in the conventional heat generating devices, a part of obtained thermal energy is used for separate state change, or high energy is added in order to generate thermal energy, whereby the energy efficiency is low. Thus, sufficient power saving has not been achieved.

Furthermore, there has been a conventional power generating apparatus such as that of Patent Literature 3, for example, in which exhaust heat is used and a thermoelectric module is used, whereby power is extracted. However, since usage of the exhaust heat which is unstable is a prerequisite, supply of a heat source is unstable. Control of the heat energy itself is difficult in view of the facility properties. Control for temporarily storing (buffering) the quantity of heat, for example, is required. Thus, the function therefor becomes significantly complicated. Further, when excessive heat that exceeds the durability of thermoelectric conversion module is supplied from the heat source, a limiter for the thermoelectric conversion module is actuated to stop power generation. In practice, when the exhaust heat is used, taking extra care is important. This is a cause of the fact that power generation using temperature differences has not became widespread.

As described above, in the conventional power generating apparatus, the heat energy the temperature of which is controlled to be significantly stable needs to be supplied from the heat source in order to stably generate power with heat from the heat source by use of the thermoelectric conversion module. In view of this, there has also been a problem that, even if heat is generated by use of, as a heat source, power derived from natural energy, control of exhaust heat requires extra care so that stable operation is difficult.

Moreover, for example, an excellent heat source that is capable of generating heat by using weak and unstable power derived from natural energy, and that can sufficiently allow heat absorbing characteristics provided to a thermoelectric conversion module, is ideal. However, a heat source having such excellent heat generation properties has not been known yet.

Therefore, if there is a heat source capable of stably utilizing power derived from natural energy such as water power, wind power, and sunlight, an excellent power generating apparatus having a high utility value also from the viewpoint of efficient use of natural energy can be realized. However, such an apparatus has not been known yet. That is, a power generating apparatus capable of stably supplying power at low cost even when using an unstable energy source, such as natural energy, the power generation amount of which is small, has not been known yet.

Further, if there is a heat source that exerts a high heat generation effect while saving power, a heating apparatus or a warming apparatus that exerts a high heat generation effect while saving power, compared to existing apparatuses, could be realized with use of the heat source. However, such a heat source has not been known yet.

The present invention has been made in order to solve the aforementioned problems, and an object thereof is to provide a heat generating device capable of efficiently maintaining power generation for a long time at low cost while saving power, and to provide the use of the heat generating device.

### Solution to Problem

As a result of intensive research, the present inventor has found a new excellent heat generating device capable of having unprecedented heat generation property in which, when voltage is applied in a state where certain powder is mixed, a temperature rise is caused in a short time, and further, the temperature is kept to be fixed after a lapse of a certain time period. Further, the present inventor has derived a power generating apparatus which can be stably operated by heat generation performed by the heat generating device, in combination with a thermoelectric element.

Therefore, a heat generating device disclosed by the present application includes
a hollow container an inside of which is electrically insulated,
a pair of opposed electrodes which are housed in the container and which are separately opposed to each other, and
a heat generating body which is housed between the opposed electrodes in the container and contains silicon powder and carbon powder in a mixed state.

Since the hollow container the inside of which is electrically insulated, the pair of opposed electrodes which are housed in the container and which are separately opposed to each other, and the heat generating body which is housed between the opposed electrodes in the container and contains silicon powder and carbon powder in a mixed state, are included, current propagates through carbon powder having electric conductivity upon application of voltage to the opposed electrodes, heat is given to the silicon powder coexisting in the mixed state by propagation of the current, and the heat generating body generates heat. Accordingly, power can be generated with a simple configuration while power is being saved, and the heat generating device can be used as a heat source also appropriate to maintain a warm state.

Moreover, in the heat generating device disclosed herein, the heat generating body has a density of 0.85 g/cm³ to 1.30 g/cm³, as needed. Since the heat generating body has a density of 0.85 g/cm³ to 1.30 g/cm³, heat can be stably generated at a lower resistance value.

Further, in the heat generating device disclosed herein, the density of the heat generating body is smaller when an average powder diameter and/or total weight of the carbon powder contained in the heat generating body is larger, as needed. Since the density of the heat generating body is smaller when an average powder diameter and/or total weight of the carbon powder contained in the heat generating body is larger, as needed, the electric conductivity of the carbon powder acts to cause the current to easily flow under a high porosity (low density) state, whereas the insulation properties of the silicon powder acts under a low porosity (high density) state. As a result of the complementary actions of the two types of powder, high heat energy can be more stably kept high.

Moreover, in the heat generating device disclosed herein, the heat generating body contains ferric oxide and/or aluminum oxide in a powder state, as needed. For example, Fe₂O₃, Al₂O₃, or the like is contained. Since the heat generating body contains the ferric oxide and/or aluminum oxide in a powder state, heat energy generated by the ferric oxide and/or aluminum oxide in the powder state is reliably held in the heat generating body, and the ferric oxide and/or aluminum oxide in the powder state has an influence on the resistance (particularly, initial resistance) during heat generation. Accordingly, a desired resistance value can be freely set according to blending of the ferric oxide and/or aluminum oxide in the powder state.

Further, in the heat generating device disclosed herein, the heat generating body contains incineration ash and/or mineral in a powder state, as needed. Since the heat generating body contains incineration ash and/or mineral in a powder state, heat energy generated by the incineration ash and/or mineral is reliably held in the heat generating body. Accordingly, a high heat generation amount can be stably maintained.

Further, a power generating apparatus disclosed herein, includes
heat generating means which is formed of the heat generating device and which generates heat upon supply of external power from an outside to the opposed electrodes, and
thermoelectric means which is disposed so as to be close to the heat generating means, of which an opposing surface side opposed to the heat generating means is heated, of which a rear surface side is cooled, and which converts a temperature difference between the opposing surface side and the rear surface side into electric energy.

Since the heat generating means which is formed of a heat generating body which contains silicon powder and carbon powder in a mixed state and which generates heat upon supply of external power from an outside to the opposed electrodes, and the thermoelectric means of which an opposing surface is disposed so as to be close to the heat generating means and which converts the temperature difference between the opposing surface and the rear surface into electric energy, are included, current propagates through the carbon powder having electric conductivity upon application of voltage to the opposed electrodes, heat is given to the silicon powder coexisting in the mixed state by propagation of the current, and the heat generating body significantly efficiently generates heat. By this heat generation, a large temperature difference is generated in the thermoelectric means, and large power can be stably generated as a result of the temperature difference.

Further, in the power generating apparatus disclosed herein, the thermoelectric means is formed of a Seebeck element or a Thomson element, as needed. Since the thermoelectric means is formed of a Seebeck element or a Thomson element, the heat generating means can generate heat with a simpler configuration while saving power. Accordingly, power can be stably generated by the thermoelectric means.

Moreover, in the power generating apparatus disclosed herein, the heat generating body contains incineration ash and/or mineral in a powder state, as needed. Since the heat generating body contains incineration ash and/or mineral in a powder state, generated heat energy is reliably held in the heat generating body when the carbon powder contained in the mixed state is expanded by energization with a lapse of the heat generation time because the incineration ash and/or mineral in the powder state is contained. Further, an increase of contact surfaces formed among the inter-carbon powder is suppressed, the electric conductivity of the heat generating body is suppressed, and reduction of a resistance component is suppressed. Accordingly, high heat generating performance can be maintained with time.

Further, in the power generating apparatus disclosed herein, the heat generating means is formed into a cylindrical body, and the thermoelectric means surrounds the heat generating means, as needed. Since the heat generating means is formed into a cylindrical body and the thermoelectric means surrounds the heat generating means, heat energy generated toward all directions from the heat generating means can be completely propagated to the opposed surface of the thermoelectric means. Accordingly, the thermoelectric means can efficiently convert the heat energy from the thermoelectric means into power.

Moreover, the power generating apparatus disclosed herein, includes heat storing means which is formed so as to be disposed between the heat generating means and the thermoelectric means and which stores heat generated by heat generation performed by the heat generating means, as needed. Since the heat storing means temporarily holds heat generated by heat generation performed by the heat generating means, the heat energy generated by heat generation performed by the heat generating means is not discharged or discarded but is held by the heat storing means even when the heat energy becomes excessive. Accordingly, power can be stably generated by the thermoelectric means with higher energy efficiency. In addition, even when heat generation being performed by the heat generating means suddenly changes or stops, operation of the thermoelectric means can be continued with the heat energy held by the heat storing means, and thus, the operation stability can also be enhanced. Further, since the heat storing means uniformizes and holds heat generated by heat generation performed by the heat generating means, the temperature (optimum temperature) for optimizing (maximizing) the power conversion efficiency of the thermoelectric means is maintained to enable stable supply. Accordingly, power can be generated under a condition where the heat generating performance of the thermoelectric means is optimized. Power can be stably and continuously generated by the thermoelectric means with higher energy efficiency.

Further, the power generating apparatus disclosed herein, includes cooling means which is disposed so as to be close to a rear surface side of the thermoelectric means and which cools the rear surface of the thermoelectric means, as needed. Since the cooling means which cools the rear surface of the thermoelectric means is included, a larger temperature difference is generated in the thermoelectric means. Accordingly, larger power can be generated by the thermoelectric means.

Further, in the power generating apparatus disclosed herein, the external power is supplied by power derived from natural energy, the cooling means is formed, as needed. Since the external power is supplied by power derived from natural energy such as solar energy, and the cooling means is provided(which may be the shadow of a solar energy panel, for example), efficient use of the natural energy can be more efficiently performed, and power can be stably and continuously generated by the thermoelectric means.

Moreover, in the power generating apparatus disclosed herein, the cooling means is formed from a fluid having cooling performance, as needed. Since the cooling means is formed from a fluid (which may be gas or may be a liquid), the cooling means performs more efficient cooling by using the diffusion property of the fluid so that a larger temperature difference is generated in the thermoelectric means. Accordingly, effective use of the natural energy can be more efficiently performed, and power can be stably and continuously generated by the thermoelectric means.

Further, in the power generating apparatus disclosed herein, the external power is supplied by power derived from natural energy based on dynamic energy of a fluid, and the cooling means cools the rear surface of the thermoelectric means by using static energy of the fluid, as needed. Since the fluid forming the cooling means also serves as a fluid (which may be gas or may be a liquid) for generating the natural energy, the fluid used for power generation using natural energy is reused from a different energy viewpoint so that a larger temperature difference is efficiently generated in the thermoelectric means. Accordingly, more effective use of the natural energy can be performed, and power can be stably and continuously generated by the thermoelectric means.

A heating apparatus including the heat generating device disclosed herein, includes
heat generating means which is formed of the heat generating device, and which generates heat upon supply of external power from an outside to the opposed electrodes,
a heat pipe having a longitudinal shape,
a heat storing part which is made from a metal ingot, and in which a housing portion formed of a through hole in close contact with at least a longitudinal surface of the heat generating means is formed in the metal ingot, and holding portions being disposed at symmetrical positions around an arrangement position of the housing portion and being formed of through holes holding the heat pipe while being in close contact with a longitudinal surface of the heat pipe is formed in the metal ingot, and
control means which controls heat generation start and heat generation stop of the heat generating means such that thermal energy stored in the heat storing part does not become lower than energy dissipated by the heat pipe.

The heating apparatus including the heat generating device disclosed herein includes the heat generating means which is formed of the heat generating device, and which generates heat upon supply of external power from an outside to the opposed electrodes, the heat pipe having a longitudinal shape, the heat storing part which is made from a metal ingot, and in which a housing portion formed of a through hole in close contact with at least a longitudinal surface of the heat generating means is formed in the metal ingot, and holding portions being disposed at symmetrical positions around an arrangement position of the housing portion and being formed of through holes holding the heat pipe while being in close contact with a longitudinal surface of the heat pipe is formed in the metal ingot, and the control means which controls heat generation start and heat generation stop of the heat generating means such that thermal energy stored in the heat storing part does not become lower than energy dissipated by the heat pipe. Therefore, due to the excellent heat generation efficiency of the heat generating means, the heat storing part can maintain the temperature for a long time under control performed by the control means, only by one temperature rise in the heat generating means. Thus, the dissipated heat energy transferred through and dissipated by the heat pipe is fixed. Accordingly, heating can be stably performed for a long time.

Further, in the heating apparatus disclosed herein, the metal ingot is made from an aluminum alloy, as needed. Since the metal ingot is made from an aluminum alloy, high latent heat characteristics of the aluminum alloy provides a high warming effect. Accordingly, an excellent heating effect can be exerted while more power is being saved.

Moreover, in the heating apparatus disclosed herein, the heat generating means is formed such that the housing portion and the holding portions are each equally divided into two, as needed. Since the heat generating means is formed such that the housing portion and the holding portions are each equally divided into two, the heat generating means can uniformly and stably supply a heat source to the heat pipe. Thus, dissipated heat energy transferred through and dissipated by the heat pipe is fixed. Accordingly, heating can be stably performed for a longer time.

Further, a warming apparatus disclosed herein, includes
the heating apparatus, and
a housing container in which a heat pipe accommodating portion accommodating the heat pipe of the heating apparatus is provided, and which airtightly or non-airtightly houses a medium made from a liquid or gas.

The medium in the housing container is warmed or vaporized. Since the heating apparatus, and the housing container in which a heat pipe accommodating portion accommodating the heat pipe of the heating apparatus is provided, and which airtightly or non-airtightly houses a medium made from a liquid or gas are included, the medium in the housing container is heated or vaporized by use of heat stably dissipated by the heat pipe. Accordingly, when the medium is a liquid, the liquid in the housing container can be warmed with higher heat retaining property, whereas when the medium is gas, a liquid is taken into the housing container from the outside, and the liquid can be quickly vaporized. Thus, use as a vapor generator or a humidifier is possible.

Moreover, the warming apparatus disclosed herein is covered with a thermal insulating material, as needed. Since the warming apparatus is covered with the thermal insulating material, the heat retaining property of the housing container is further enhanced. Accordingly, a warming apparatus having higher heat retaining property can be implemented.

### Brief Description of Drawings

[Figure 1] Figure 1 shows a configuration diagram of a cross-sectional view of a heat generating device according to a first embodiment of the present invention.
[Figure 2] Figure 2 shows an explanatory diagram of a perspective view of the heat generating device according to the first embodiment of the present invention.
[Figure 3] Figure 3 shows a configuration diagram of the heat generating device according to the first embodiment of the present invention.
[Figure 4] Figure 4 shows a configuration diagram of the heat generating device according to the first embodiment of the present invention.
[Figure 5] Figure 5 shows a configuration diagram of the heat generating device according to the first embodiment of the present invention.
[Figure 6] Figure 6 shows an explanatory diagram for the characteristics of resistance value change in accordance with a temperature rise in the heat generating device according to the first embodiment of the present invention, based on actual measurement.
[Figure 7] Figure 7(a) shows an explanatory diagram illustrating the configuration of a power generating apparatus according to the first embodiment of the present invention, and Figure 7(b) shows a configuration example of thermoelectric means.
[Figure 8] Figure 8 shows a configuration diagram of a perspective view of a power generating apparatus according to a second embodiment of the present invention.
[Figure 9] Figure 9 shows a configuration diagram of a perspective view of a power generating apparatus according to a third embodiment of the present invention.
[Figure 10] Figure 10 shows a configuration diagram of a power generating apparatus according to a fourth embodiment of the present invention.
[Figure 11] Figure 11 shows a configuration diagram of the power generating apparatus using a heat sink according to the fourth embodiment of the present invention.
[Figure 12] Figure 12 shows a configuration diagram of the power generating apparatus using a heat sink according to the fourth embodiment of the present invention.
[Figure 13] Figure 13 is an explanatory diagram of time-varying change of an electric power amount by the power generating apparatus according to the fourth embodiment of the present invention.
[Figure 14] Figure 14 shows a configuration diagram of the power generating apparatus using a heat sink according to the fourth embodiment of the present invention.
[Figure 15] Figure 15 shows a configuration diagram of the power generating apparatus using a heat sink according to the fourth embodiment of the present invention.
[Figure 16] Figure 16(a) shows a configuration diagram of the power generating apparatus using a heat sink according to the fourth embodiment of the present invention, and
Figure 16(b) shows an explanatory diagram of transition of a thermosensor switch and temperature change.
[Figure 17] Figure 17(a) shows a perspective view of a configuration of a power generating apparatus according to a fifth embodiment of the present invention, Figure 17(b) shows a cross-sectional view of the configuration, and Figure 17(c) shows a perspective view of the configuration.
[Figure 18] Figure 18 shows a configuration diagram of a heating apparatus according to a sixth embodiment of the present invention.
[Figure 19] Figure 19 shows a configuration diagram of the heating apparatus according to the sixth embodiment of the present invention.
[Figure 20] Figure 20 shows a configuration diagram of the heating apparatus according to the sixth embodiment of the present invention.
[Figure 21] Figure 21 shows a configuration diagram of the heating apparatus according to the sixth embodiment of the present invention.
[Figure 22] Figure 22 shows an explanatory diagram of the control operation of control means of the heating apparatus according to the sixth embodiment of the present invention.
[Figure 23] Figure 23 shows an explanatory diagram of a heating apparatus according to a seventh embodiment of the present invention.
[Figure 24] Figure 24 shows an explanatory diagram of the heating apparatus according to the seventh embodiment of the present invention.
[Figure 25] Figure 25 shows a measurement result of time-varying temperature change obtained when voltage was applied, for 20 minutes, to a heat generating body constituting a power generating apparatus according to example 1 of the present invention.
[Figure 26] Figure 26 shows a measurement result of time-varying temperature change of a heating apparatus according to example 2 of the present invention.

### Description of Embodiments

### (First Embodiment)

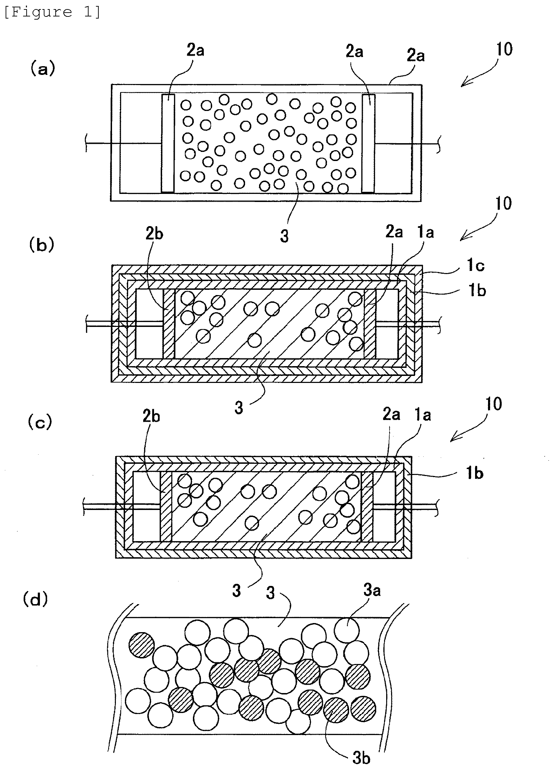

A power generating apparatus according to the first embodiment of the present application and the use thereof will be described in accordance with Figures 1 to 7.

As illustrated in Figure 1(a), a heat generating device (heat generating means 10) according to the first embodiment is configured to include a hollow container 1 the inside of which is electrically insulated, a pair of opposed electrodes 2 consisting of a first electrode 2a and a second electrode 2b which are housed in the container 1 and are separately opposed to each other, and a heat generating body 3 which is housed between the opposed electrodes 2 in the container 1 and is made from silicon powder 3a and carbon powder 3b in a mixed state.

The material of the container 1 is not limited to a particular one which may be metal or may be non-metal, as long as the inside of the container 1 is electrically insulated. However, as illustrated in Figure 1(b), at least the inner portion (inner side surfaces) of the container 1 is preferably formed of a heat conducting material 1b having surfaces covered with an inner-side insulating portion 1a which has been electrically insulated.

The heat conducting material 1b is not limited to a particular material which may be metal or may be non-metal as long as the material has heat conductivity. Aluminum, copper, or ceramic is preferably used therefor.

The inner-side insulating portion 1a is not limited to a particular portion as long as the position has insulation properties. As one example thereof, a coating formed by alumite treatment may be used. Alternatively, a ceramic coating may be used. Metal such as aluminum or copper having heat conductivity may be used as the heat conducting material 1b. Alternatively, ceramic may be used.

For example, when aluminum is used as the heat conducting material 1b, a coating formed by alumite treatment, which has high affinity with aluminum, is preferably used as the inner-side insulating portion 1a. In this case, weight reduction is achieved by the aluminum and the formation is achieved only by alumite treatment on a surface of the aluminum, whereby the production and handling are made easy. Alternatively, for example, when ceramic is used as the heat conducting material 1b, the ceramic can also be used as it is for the inner-side insulating portion 1a, whereby production and handling are made easy with the simple configuration.

Moreover, regarding the material of the container 1, the outer surfaces (outer-side surfaces) of the container 1 are also preferably formed from the heat conducting material 1b having surfaces coated with the outer-side insulating portion 1c having undergone electric insulation treatment, as illustrated in Figure 1(b). A coating formed by alumite treatment is preferably used for the outer-side insulating portion 1c, similar to the inner-side insulating portion 1a, when aluminum is used as the heat conducting material 1b, for example. In addition, for example, when ceramic is used as the heat conducting material 1b, the ceramic can be used as it is also for the outer-side insulating portion 1c. Accordingly, the production and handling are made easy.

As described above, in the outer surfaces of the container 1, the outer-side insulating portion 1c having undergone electric insulation treatment enhances both the insulation properties and heat resistance of the outer portion of the container 1. Accordingly, regarding the strength, the heat generating means 10 is more stably formed so as to be firm against heat generated by the heat generating body, whereby power can be more stably generated by thermoelectric means 20. Due to the insulation properties of the outer surfaces of the container 1, direct heating of a liquid such as water can be easily performed, for example. As an application of this, use as a heat pipe using transfer of heat generated by contact with a hydraulic fluid is possible.

Note that the material of the container 1 is not limited to the heat conducting material 1b covered with the inner-side insulating portion 1a and the outer-side insulating portion 1c. For example, an aspect in which only the inside of the container 1 is formed from the heat conducting material 1b a surface of which is covered with the inner-side insulating portion 1a having undergone electric insulation treatment, as illustrated in Figure 1(c), is sufficiently preferable because high insulation properties and high heat resistance are provided.

Further, for example, when aluminum is used as the heat conducting material 1b and a coating formed by alumite treatment is used as the inner-side insulating portion 1a, at least the inner side of the container 1 is formed from aluminum which has undergone alumite treatment. Accordingly, due to the aluminum having undergone alumite treatment, the container 1 is formed from aluminum which is light metal and the inner side of the container 1 is electrically insulated so that the heat resistance of the inner side of the container 1 is also enhanced. Thus, toughness against a temperature rise caused by heat generated by the heat generating body inside the container 1, and further, the carrying easiness can be achieved. In addition, for example, when ceramic is used as the heat conducting material 1b, the ceramic also can be used as it is as the inner-side insulating portion 1a, whereby the production and handling can be made easy with the simple configuration.

Note that the material of the container 1 is not limited to the aforementioned materials. For example, a resin material such as plastic or glass may be used therefor.

The shapes of the first electrode 2a and the second electrode 2b consisting the opposed electrodes 2 are not limited to particular shapes, and may be linear shapes or flat plate shapes. However, flat plate shapes are more preferable. When flat plate shapes are adopted and the areas thereof are changed according to various applications, control can be freely performed so as to obtain a desired temperature rising speed.

Further, either one of AC and DC may be used as voltage to be applied. Therefore, power source supply can be freely designed to be power source supply from a compact dry battery or large capacity power source supply from an AC power supply receptable, for example. Thus, space saving and upsizing can be achieved according to an installation place or needs. This allows flexible designing.

The heat generating body 3 is formed so as to have a mixed state in which the silicon powder 3a and the carbon powder 3b are mixed, as illustrated in Figure 1(d). In the mixed state, the mixed degree of the powders is not limited to a particular degree. The silicon powder 3a and the carbon powder 3b only need to be dispersed without bias. A state in which the powders are uniformly mixed is more preferable. A method for forming the mixed state is not limited to a particular method. For example, the mixed state can be formed by stirring or vibrating the silicon powder 3a and the carbon powder 3b.

The silicon powder 3a as a raw material is not limited to a particular powder, but regenerated silicon which is secondarily discharged and discarded in large quantities during production of semiconductors may be used as the raw material. This leads to effective reuse of the resources. In light of these circumstances, the silicon powder 3a may contain silicon carbide powder as an additional component.

Further, the carbon powder 3b is not limited to a particular material, but, as the raw material therefor, carbon (e.g., carbon black) which is secondarily discharged and discarded in large quantities during production of batteries such as secondary batteries, is preferably used. This provides an excellent advantageous effect that, as the result of the effective use through reuse of resources, not only the production cost can be suppressed but also an environmental burden can be suppressed.

The particle diameter of each of the silicon powder 3a and the carbon powder 3b is not limited to a particular diameter, but is preferably 5 to 300 µm. The reason for this is that it was confirmed that, when 300-µm powder was mixed, the resistance value of the heat generating body 3 was adjustable and sufficient heat was generated, whereas, when the particle size thereof was 300 µm or larger, the powder was impracticable because the resistance value was unstable and temperature unevenness was generated in the container. As described above, in the heat generating means 10, when the silicon powder 3a and the carbon powder 3b each have a particle diameter of 5 to 300 µm, the mixed state for allowing current to be more likely to flow between the opposed electrodes 2 can be easily formed. Thus, the heat exchange efficiency can be more stably enhanced, heat can be generated while power is saved, and further, power can be stably generated by means of the thermoelectric means 20 as a heat source appropriate for maintaining the warm state.

Also, the particle diameter of each of the silicon powder 3a and the particle diameter of the carbon powder 3b is preferably set to 5 to 300 since a resistance value appropriate for causing heat generation is easily obtained by the entire heat generating body 3. The particle diameter is more preferably set to 30 to 180 µm. The appropriate resistance value is preferably 5 to 20 Ω, and is more preferably 8 Ω. Since such a resistance value is a load resistance value which is measured from the power source device side, the power source designing becomes simple. In addition, control of the power source can be performed not through current control CC but through voltage control CV. Thus, driving using not a dedicated power source but a common inexpensive power source device can be performed. Thus, even when a commercially available rechargeable battery or dry battery is used as the power source, stable power generation can be performed.

Further, by the control of the particle diameters of the silicon powder 3a and the carbon powder 3b, the amount of heat generation can be controlled. For example, control of reducing the resistance value so as to increase the amount of heat generation by using the silicon powder 3a and the carbon powder 3b the particle diameters of which are set to be small, and increasing the resistance value so as to suppress the amount of heat generation by using the silicon powder 3a and the carbon powder 3b the particle diameters of which are set to be large, can be performed.

Moreover, through adjustment of the blending ratio of the silicon powder 3a and the carbon powder 3b, the heat generation property(e.g., a resistance value) can also be controlled. For example, simple control of, when the ratio of the silicon powder 3a is increased, being able to increase the amount of heat generation because the ratio of a component which easily generates heat and which has insulation properties is likely to increase, and of, when the ratio of the carbon powder 3b is increased, further suppressing the amount of heat generation because the ratio of an electrically conductive component is likely to increase, can be performed.

Further, when the temperature of heat generated by the heat generating body 3 has exceeded about 800°C, the silicon powder 3a having semiconductor characteristics is shifted to a conductor state so that the resistance value thereof continuously decreases without any fluctuation. Thus, stable resistance control can be realized. Regarding this point, a conventional heat generating body (e.g., an SiC heater) that generates heat by using silicon has been known, but such a heat generating body has characteristics of having a resistance value which increases while fluctuating in accordance with heat generation, and thus, simple and appropriate heat generation control (resistance value control) therefor is difficult. In contrast, in the heat generating body 3 according to the present embodiment, the resistance value thereof continuously decreases without any fluctuation, even in a high-temperature region exceeding about 800°C in accordance with heat generation. Accordingly, appropriate heat generation control (resistance value control) which is significantly more excellent than the conventional one can be performed. Further, the heat generating body 3 is excellent and conventionally unprecedent from the viewpoint of power saving because the amount of required power becomes smaller in the higher temperature region. As a power source design in the heat generating body 3 according to the present embodiment, a simple power supply design can be addressed such that the heat generating body 3 is designed to have about 8 Q at ordinary temperature, for example, and, even for a case of being used in a high-temperature region, the lower limit is set to about the half (about 4 Ω) of that at ordinary temperature.

Regarding the heat generating body according to the present embodiment, a ceramic-made pipe (container 1) having a diameter of 10 ϕ and a length of 100 mm was filled with the silicon powder 3a and the carbon powder 3b constituting the heat generating body 3 by a volume ratio of 1:1, the total weight of the silicon powder 3a and the carbon powder 3b was changed to change the density of the heat generating body 3 (powder total weight (g)/the volume of the container 1 (cm³)), and the resistance value of the heat generating body 3 was measured. The obtained result is shown below.

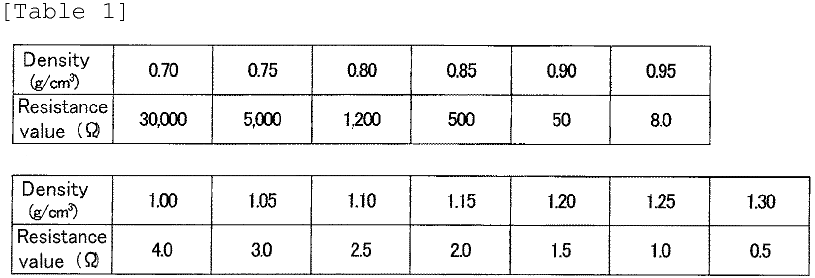

From the obtained result, the density of the heat generating body 3 is preferably 0.85 g/cm³ to 1.30 g/cm³ because heat can be generated by a lower resistance value. The density is more preferably 0.90 g/cm³ to 1.10 g/cm³ because heat can be stably generated while more power is saved. For example, the density can be set to 1.00 g/cm³. In this case, the resistance value is 4 Ω. Therefore, it was confirmed that properties having good handleability can be obtained.

Further, from the above result, when the volume ratio of the silicon powder 3a: the carbon powder 3b is 1:1, for example, the basic resistance value can be set to 4 Ω, for example, as described above. Moreover, when the ratio of the silicon powder 3a is increased, the resistance value of the heat generating body 3 in a high-temperature region is decreased. Thus, for example, when the ratio of the silicon powder 3a is increased to obtain the volume ratio of 1.1:0.9, the basic resistance value can be set to 3.5 Ω. As described above, desired heat generation property (the resistance value) can be obtained only by control of the density of the heat generating body 3, whereby designing can be easily performed and desired heat generation property can be simply obtained.

Moreover, the pH value of each of the silicon powder 3a and the carbon powder 3b is not limited to a particular value, but is preferably set around a neutral region. However, the pH value is not limited to this, and may be set in an acidic region or in an alkaline region.

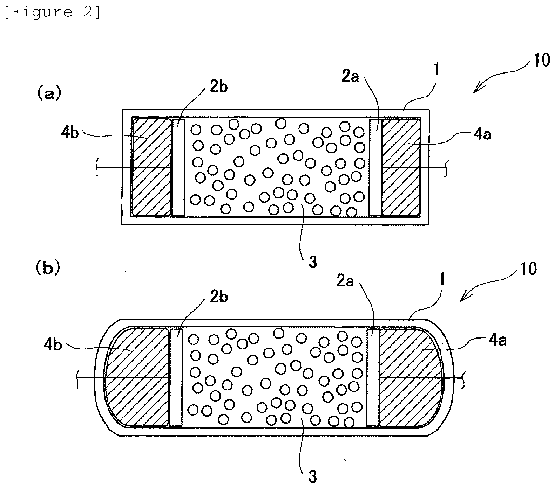

The shape of the heat generating means 10 is not limited to a particular shape, but is preferably formed into a flat plate-like shape, as illustrated in Figure 2(a). In addition, the shape may be formed into a cylindrical body, as illustrated in Figure 2(b). In addition, no particular limitation is put as long as the heat generating means 10 has a hollow body.

With this configuration, in the heat generating means 10, the startup speed of the heat source is high even while power is being saved, and further, setting of desired temperature becomes easy. Moreover, for example, the heat generating means 10 can be used for long-time warming, by using surplus power such as midnight power. In addition, it was confirmed that the heat generating means 10 can generate sufficient heat even with power as small as 3 to 10 watts, and further, exhibits extremely excellent heat generating performance of enabling a temperature rise to 1000°C (see examples which will be described later).

A mechanism by which the heat generating means 10 exerts the excellent effects has not been clarified in detail. However, since the silicon powder 3a and the carbon powder 3b constituting the heat generating body 3 are formed in the mixed state, it is inferred that, when voltage is applied to the opposed electrodes 2, current flows through the carbon powder 3b having conductivity, this current flow causes a heat generation operation of the silicon powder 3a coexisting in the mixed state, and further, the silicon powder 3a and the carbon powder 3b push each other in a narrow region with a high integration degree between the powders, and thus, the heat generating body generates heat at the atom level. Moreover, since the silicon powder 3a and the carbon powder 3b are in the mixed state in which the silicon powder 3a and the carbon powder 3b are in contact with each other, it is also inferred that, when voltage is applied to the silicon powder 3a and the carbon powder 3b, the electric orientation state of the silicon powder 3a and the carbon powder 3b is converted to an aligned state through which current can easily flow, and a condition where, by the flow of current, heat is easily generated from the silicon powder 3a mainly having insulation properties, is formed.

As described above, the power generating apparatus (the heat generating means 10) according to the first embodiment is configured to include the hollow container 1 the inside of which is electrically insulated, the pair of opposed electrodes 2 which are housed in the container 1 and which consists of the first electrode 2a and the second electrode 2b separately opposed to each other, and the heat generating body 3 which is housed between the opposed electrodes 2 in the container 1 and which contains the silicon powder 3a and the carbon powder 3b in the mixed state. Accordingly, voltage applied to the opposed electrodes 2 causes propagation of current to the carbon powder 3b having conductivity, the propagation of current gives heat to the silicon powder 3a coexisting in the mixed state so that the heat generating body 3 generates heat. Accordingly, heat can be generated with the simple configuration while power is saved, whereby, as a heat source appropriate to maintain a warm state, the heat generating means 10 can be used for various uses.

The heat generating means 10 enables a temperature rise to about 300°C with external power of about 50 W, and a temperature rise to about 800°C with external power of about 200 W. Thus, high heat energy can be obtained with extremely lower power.

Also, as illustrated in Figure 2(a), a configuration provided with elastic bodies 4 (a first elastic body 4a, a second elastic body 4b) near respective non-opposed surface sides of the opposed electrodes (the first electrode 2a and the second electrode 2b) may be formed. For example, the elastic bodies 4 may be put between the heat generating body 3 and the opposed electrodes 2 (the first electrode 2a and/or the second electrode 2b), or may be put between the container 1 (e.g., a ceramic container) and the heat generating body 3.

The elastic bodies 4 are not limited to particular bodies, but heat-resistant rubber, Teflon (registered trademark), ceramic, or the like can be used therefor, for example.

As illustrated in Figure 2(b), when the heat generating body 3 inside the container 1 is thermally expanded by heat generation, the shapes of the elastic bodies 4 as a buffer are changed and the elastic bodies 4 absorb the expansion of the heat generating body 3. Accordingly, the variation of the behavior of the mixed state of the silicon powder 3a and the carbon powder 3b (e.g., the dispersed state or the filling rate of the silicon powder 3a and the carbon powder 3b) due to expansion of the heat generating body 3 is suppressed, and deterioration of the heat generating state is suppressed, whereby the heat generating state of the heat generating body 3 is maintained. Thus, continuous heat generation can be stably realized. In addition, any damage to the container 1 caused by heat generation performed by the heat generating body 3 can be suppressed. That is, in the case where the elastic bodies 4 are provided near the respective non-opposed surfaces of the opposed electrodes 2, even when the inner volume of the container 1 is expanded by heat generation performed by the heat generating body 3, the elastic bodies function as absorbing bodies for absorbing the expansion, so that the mixed state of the silicon powder 3a and the carbon powder 3b (e.g., the dispersed state or the filling rate of the silicon powder 3a and the carbon powder 3b) are uniformized. Accordingly, even when the silicon powder 3a and the carbon powder 3b are expanded, deterioration of the heat generating state of the heat generating body 3 in accordance with the expansion is suppressed so that the amount of heat (Joule heat) generated by the heat generating body 3 can be determined by fixed electric conductivity. Thus, continuous heat generation can be stably realized. Moreover, the durability of the inside of the container 1 is also enhanced, the heat generating means 10 that has further firmness against heat generated by the heat generating body 3 and that has high strength is formed. Accordingly, heat energy is stably is supplied by the heat generating means 10, and power can be stably generated by the thermoelectric means 20.

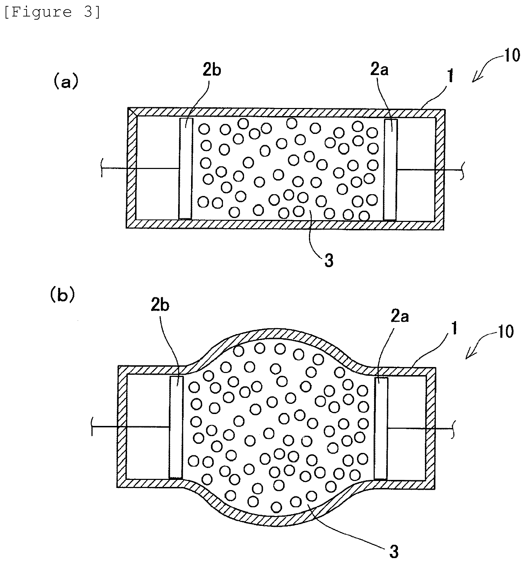

Further, as illustrated in Figure 3(a), the container 1 may be formed from an elastic body. The elastic body forming the container 1 is not limited to a particular elastic body, but the aforementioned rubber, Teflon (registered trademark), ceramic, or the like can be used therefor.

As illustrated in Figure 3(b), when the heat generating body 3 inside the container 1 is thermally expanded by heat generation, the container 1 formed from the elastic body also functions as a buffer, the shape thereof is changed by the thermal expansion, and the container 1 absorbs the expansion of the heat generating body 3. Accordingly, the variation of the behavior of the mixed state of the silicon powder 3a and the carbon powder 3b (e.g., the dispersed state or the filling rate of the silicon powder 3a and the carbon powder 3b) due to expansion of the heat generating body 3 is suppressed, deterioration of the heat generating state is suppressed, whereby the heat generating state of the heat generating body 3 is maintained. Thus, continuous heat generation can be stably implemented. Any damage to the container 1 caused by the thermal expansion of the heat generating body 3 by heat generation can be suppressed. That is, in a case where the container 1 is formed from the elastic body, even when the heat generating body 3 inside the container 1 is expanded by heat generation performed by the heat generating body 3, the container 1 functions as an absorbing body for absorbing the expansion by the effect of the elastic body so that the mixed state of the silicon powder 3a and the carbon powder 3b (e.g., the dispersed state or the filling rate of the silicon powder 3a and the carbon powder 3b) are uniformized. Accordingly, even when the silicon powder 3a and the carbon powder 3b are expanded, deterioration of the heat generating state of the heat generating body 3 in accordance with the expansion is suppressed so that the amount of heat (Joule heat) generated by the heat generating body 3 can be determined by fixed electric conductivity. Thus, continuous heat generation can be stably realized. In addition, the durability of the container 1 is enhanced. Accordingly, a power generating apparatus that has further firmness against heat generated by the heat generating body 3 and that can be more easily carried, is implemented.

As described above, in a case where the container 1 is formed from the elastic body, even when the heat generating body 3 inside the container is expanded by heat generation by the heat generating body, the container itself functions as an absorbing body for absorbing the expansion so that the mixed state of the silicon powder 3a and the carbon powder 3b (e.g., the dispersed state or the filling rate of the silicon powder 3a and the carbon powder 3b) are uniformized. Accordingly, even when the silicon powder 3a and the carbon powder 3b are expanded, deterioration of the heat generating state of the heat generating body 3 in accordance with the expansion is suppressed so that the amount of heat (Joule heat) generated by the heat generating body 3 can be determined by fixed electric conductivity. Thus, continuous heat generation can be stably realized. Moreover, the durability of the inside of the container 1 is enhanced, and the heat generating means 10 that has further firmness against heat generated by the heat generating body 3 and that has high strength is formed. Accordingly, heat energy is stably supplied by the heat generating means 10, and thus, power can be stably generated by the thermoelectric means 20.

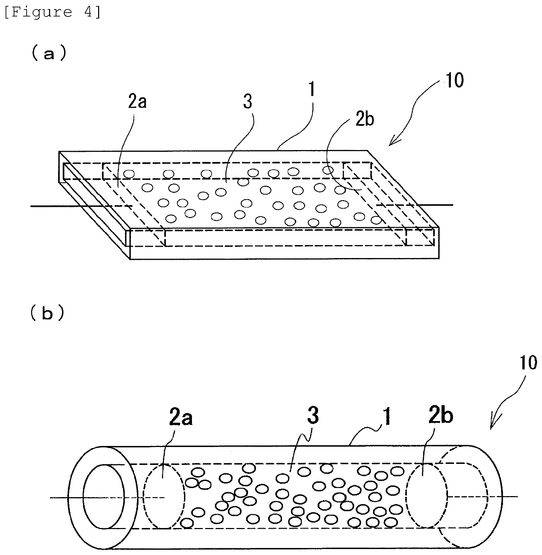

Also, the heat generating means 10 may be formed into a flat plate-like shape, as illustrated in Figure 4(a). In this case, the power generating apparatus according to the present embodiment may be formed into a thin plate shape. Thus, by the space-saving shape in which the space in the height direction is suppressed, heat energy can be stably generated.

In addition, the heat generating means 10 may be formed into a columnar shape, as illustrated in Figure 4(b). For example, the heat generating means 10 may be formed to be a stick-shaped heat generating device. Thus, since the heat generating device according to the present embodiment has a simple structure and is configured with the reduced number of required components, the operation of the device is stabilized. Accordingly, a heat generating device which can be freely carried is obtained at low cost. Due to this shape, a compact configuration is realized by use of a small-sized button battery as a power source, for example. Due to this compact configuration, when being installed in a palm site of a robot, the heat generating device can make the outer surface of the palm of the robot warm at moderate temperature (e.g., about 40 to 50°C) as warm as body temperature. A body-temperature robot which gives a sense as warm as body temperature when shaking hands is performed, can be implemented.

Since the heat generating means 10 is formed from the elastic body, the container itself serves as an absorbing body for, even when the volume of the inside of the container is expanded by heat generation performed by the heat generating body, absorbing the expansion. Thus, the heat resistance of the inside of the container is enhanced so that the heat generating means 10 which has firmness against heat generated by the heat generating body and which has high strength is formed. Accordingly, heat energy is stably supplied by the heat generating means 10, and thus, power can be stably generated.

Moreover, in the heat generating body according to the present embodiment, the heat generating body 3 contains the silicon powder 3a and the carbon powder 3b as component substances. The density of the heat generating body 3 preferably decreases as the average particle diameter and/or the total weight of the carbon powder 3b contained in the heat generating body 3 increases. When the density of the heat generating body 3 decreases as the average particle diameter and/or the total weight of the carbon powder 3b contained in the heat generating body 3 increases, as described above, the conductivity of the carbon powder 3b acts to cause the current to easily flow under a high porosity (low density) state, whereas the insulation properties of the silicon powder 3a acts under a low porosity (high density) state. As a result of complementary actions of these two types of powder, heat energy can be more stably kept high.

For example, in the heat generating body 3, the volume ratio of the carbon powder 3b can be set to 40 to 60 vol%, and the volume ratio of the silicon powder 3a can be set to 40 to 60 vol%. Since, in the heat generating body 3, the volume ratio of the carbon powder 3b is set to 40 to 60 vol% and the volume ratio of the silicon powder 3a is set to 40 to 60 vol%, as described above, the heat generating means 10 can more appropriately generate heat. Note that the other component substances are not limited to particular substances, and various substances can be mixed according to the purpose or use.

In particular, in the heat generating body according to the present embodiment, the raw materials of the silicon powder 3a and the carbon powder 3b which are the component substances of the heat generating body 3 are powder, and further, the powder state is maintained when being heated, and the powder state is maintained even after the heating is ended. The heat generating body can be easily produced because heat generating body uses the powder, as described above (essentially, the production is possible only by mixing), and also, the heat generating body further provides an excellent advantage of being easily reused because the heat generating body can be taken out after use while remaining in the powder state. Regarding this point, a conventional heat generating body is essentially heated in a solid state. Thus, the heat generating body according to the present embodiment is significantly more excellent in the production cost, the reuse cost, and the handleability, compared to the conventional one.

As another component substance contained in the heat generating body 3, a powder substance is preferable although the particle diameter thereof is not limited to a particular diameter. The heat generating body preferably contains ferric oxide and/or aluminum oxide in a powder state because the resistance value can be freely set. When the heat generating body contains ferric oxide and/or aluminum oxide in a powder state, as described above, the ferric oxide and/or aluminum oxide in a powder state gives resistance (particularly, initial resistance) in heat generation. Accordingly, a desired resistance value can be freely set by blending of the ferric oxide and/or aluminum oxide in a powder state. As another option, silicon oxide is preferably added for the same reason. This allows a desired resistance value to be freely set.

Alternatively, as another component substance contained in the heat generating body 3, incineration ash and/or mineral in a powder state is preferably contained. As the incineration ash, incineration ash that is secondarily discharged in large quantities from an iron factory or a thermal power plant may be used, and fly ash is more preferably used. Alternatively, blast furnace slug powder, silica fume, or the like may be used. Also, the mineral in a powder state is not limited to a particular one as long as the mineral is a naturally derived inorganic substance. A substance which maintains its powder state at high temperature is preferable therefor. For example, an electric stone (tourmaline) or limonite may be used. In particular, when an electric stone (tourmaline) or limonite is used, the heat radiating properties thereof can maintain the generated heat energy for a long time. The particle diameter of the incineration ash and/or mineral in a powder state is not limited to a particular diameter, but is preferably set to about 30 to 180 µm, and is more preferably set to about 30 to 70 µm.

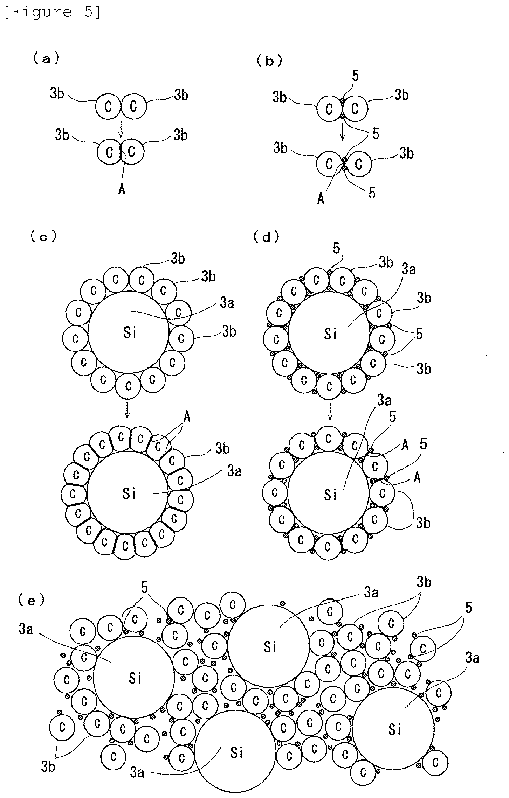

Figure 5 is an explanatory diagram of the state of the inside of the heat generating body 3, and, for simple illustration of the particle diameters of the silicon powder 3a and the carbon powder 3b, illustrates a case where the particle diameter of the silicon powder 3a is larger. However, an actual magnitude relationship between the particle diameters is not limited to that illustrated in Figure 5.

In the heat generating body 3, as illustrated in Figure 5(a), the carbon powder 3b contained while being in the mixed state is expanded by current flowing therethrough, with a lapse of a heat generating time, and the contact surface a between the carbon powder 3b is increased. By the increase in the contact surface a, the conductivity in the heat generating body 3 is increased and the resistance component is reduced because the carbon powder 3b has electric conductivity. Thus, the heat generating performance is likely to be gradually reduced with time.

In contrast, in the case where incineration ash and/or mineral 5 in a powder state is contained in the heat generating body 3, as illustrated in Figure 5(b), when the carbon powder 3b contained while being in the mixed state is expanded by current flowing therethrough, with a lapse of a heat generating time, increase in the contact surface a formed between the carbon powder 3b is suppressed because the incineration ash and/or mineral 5 in a powder state is contained. Accordingly, the electric conductivity in the heat generating body 3 is suppressed, reduction of the resistance component is suppressed, and thus, the heat generating performance can be kept high with time.

That is, in the case where the incineration ash and/or mineral 5 in a powder state is not contained in the heat generating body 3, the carbon powder 3b is expanded by current flowing therethrough (energization) while the silicon powder 3a and the carbon powder 3b are in the mixed state in the heat generating body 3 as illustrated in Figure 5(c). Thus, the contact surface a between the carbon powder 3b is increased, and the heat generating performance is likely to be gently reduced with time. In contrast, in the case where the incineration ash and/or mineral 5 in a powder state is contained in the heat generating body 3, even when the carbon powder 3b is expanded by current flowing therethrough (energization) in the heat generating body 3, increase in the contact surface a between the carbon powder 3b is suppressed, as illustrated in Figure 5(d). Thus, the heat generating performance can be kept high with time.

As described above, when the incineration ash and/or mineral 5 in a powder state is contained in the heat generating body 3, as illustrated in Figure 5(e), the connection relationship between the silicon powder 3a and the carbon powder 3b is uniformized, irrespective of expansion of the carbon powder 3b by current flowing therethrough (energization). Accordingly, the electric conductivity can be kept fixed in the entire heat generating body 3. Moreover, the diffused state of the silicon powder 3a and the carbon powder 3b is uniformized by the incineration ash and/or mineral 5 in a powder state, and thus, the amount of heat (Joule heat) can be determined by the fixed electric conductivity in the heat generating body 3, irrespective of expansion of the carbon powder 3b by current flowing therethrough (energization).

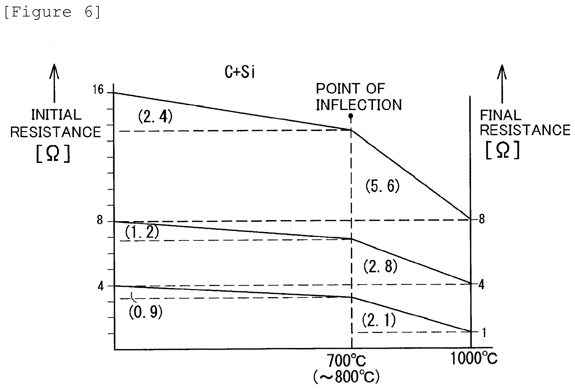

In addition, according to the confirmation made by the present inventor, the characteristics obtained on the basis of the measurement of change of the resistance value with a temperature rise in the heat generating device according to the present embodiment are shown in Figure 6. The heat generating device according to the present embodiment has the characteristics that the resistance value is reduced from the initial resistance with a temperature rise, as shown in Figure 6. On the basis of this, power control can be performed by control based on voltage (CV) without involving control based on current (CC) so that simpler control can be performed. The inclination of a line segment (the change amount of the resistance value with respect to the temperature rise) shown in the graph in Figure 6 can be controlled with use of the ratio of the silicon powder 3a and the carbon powder 3b. Also, in particular, a point of inflection generated around 700 to 800°C can be controlled by adjustment of the particle sizes of the silicon powder 3a and the carbon powder 3b (particularly, the particle size of the silicon powder 3a). That is, the point of inflection can be brought closer to 700°C when the particle size is set to be smaller, while the point of inflection can be brought closer to 800°C when the particle size is set to be larger, whereby the resistance characteristics can be easily designed. Further, the resistance value at 1000°C is more preferably about 7 to 8 Ω. In control of the resistance value, the resistance value (particularly, the initial resistance) can be increased by addition of aforementioned ferric oxide powder, aluminum oxide powder, incineration ash powder such as fly ash, or mineral powder. Also in view of this point, the resistance characteristics can be easily designed.

The heat generating device (the heat generating means 10) according to the present embodiment can be used as various heat sources because the aforementioned excellent characteristics are exerted. The application range thereof is wide. As one example, the heat generating device can be used for a power generating apparatus.

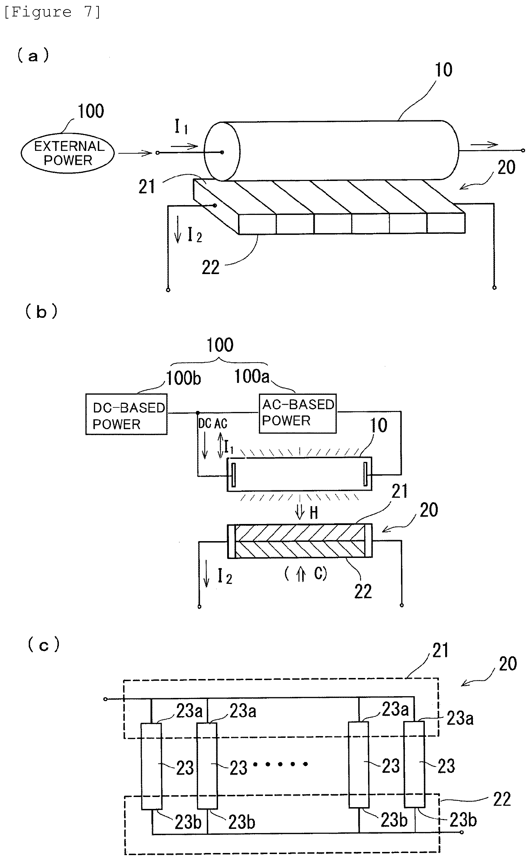

As illustrated in Figure 7(a), the power generating apparatus according to the first embodiment generates power upon supply of external power 100 from the outside, includes the aforementioned heat generating device, and is configured to include the heat generating means 10 that generates heat by supply of the external power 100 to the opposed electrodes, and the thermoelectric means 20 which has an opposing surface 21 and a rear surface 22, in which the opposing surface 21 is disposed so as to be close to the heat generating means 10, and which converts the temperature difference between the opposing surface 21 and the rear surface 22 to electric energy.

With this configuration, as illustrated in Figure 7(b), heat energy (H) is radiated to the surrounding area by heat generation performed by the heat generating means 10, and the opposing surface 21 of the thermoelectric means 20 receives the heat energy (H). On the other hand, the rear surface 22 disposed on the rear side of the thermoelectric means 20 is cooled (C) by the outside air. As a result, a large temperature difference between the opposing surface 21 and the rear surface 22 is generated.

Also, since the heat generating means 10 has a characteristic of generating heat, irrespective of the directivity of power source current, the heat generating means 10 can generate heat from both AC and DC power sources in the same manner without changing the circuit configuration thereof. Due to this excellent property, both when the external power 100 is AC-based power 100a which is AC and when the external power 100 is DC-based power 100b which is DC, as illustrated in Figure 7(b), heat can be generated in the same manner without changing the circuit configuration. Accordingly, the external power 100 can be configured to include the AC-based power 100a only or the DC-based power 100b only, and further, can be configured as a hybrid (AC/DC hybrid) in which the AC-based power 100a and the DC-based power 100b are combined.

As described above, heat is generated by current flowing through the heat generating means 10, as illustrated in Figures 7(a) and 7(b), irrespective of whether current I₁ supplied from the external power 100 is DC or AC, and a large temperature difference is generated between the opposing surface 21 and the rear surface 22 of the thermoelectric means 20. As a result, power for causing current I₂ to flow through the thermoelectric means 20 can be obtained. That is, even when the external power 100 is low, large power can be stably taken out from the thermoelectric means 20 since the heat energy (H) efficiently obtained by the heat generating means 10 and the cooling (C) by the outside air are combined.

The thermoelectric means 20 is not limited to particular means as long as the means has a property (thermoelectric property) of converting a temperature difference to electric energy. However, as illustrated in Figure 7(c), a plurality of metal pieces 23 each having one end 23a and the other end 23b are included, the ends 23a constitute the opposing surface 21, and the other ends 23b constitute the rear surface 22. As the thermoelectric means 20 thus configured, the thermoelectric means 20 is preferably formed of a Seebeck element or a Thomson element. The Seebeck element is more preferably used.

The Seebeck element uses a physical phenomenon (Seebeck effect) in which the temperature difference generated between both ends of an object is directly converted to electric energy, and can easily generate power by using the temperature difference between the ends 23a which are turned to be a high temperature side by the heat generating means 10 and the other ends 23b which are turned to be a low temperature side compared to the ends 23a, in the aforementioned metal pieces 23.

The type of the metal pieces 23 is not limited to a particular type as long as the metal pieces 23 are metal. For example, copper or aluminum may be used therefor. When the thermoelectric means 20 is formed from a Seebeck element or a Thomson element, as described above, a simpler configuration can be formed, and power can be stably generated by the thermoelectric means 20.

### (Second Embodiment)

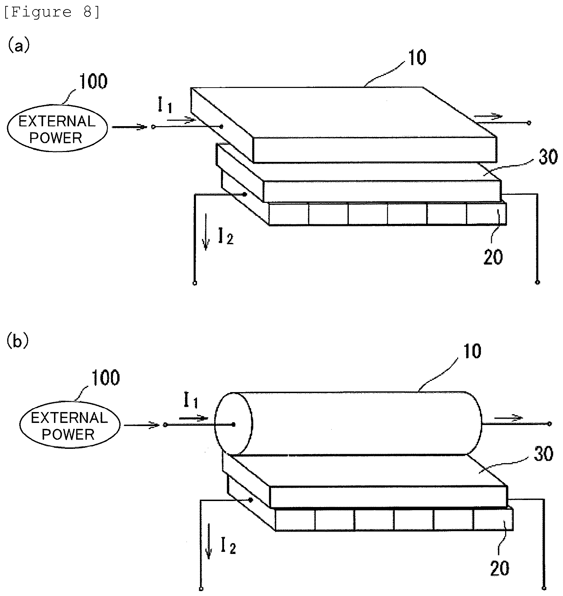

A power generating apparatus according to a second embodiment of the present application will be described in accordance with the configuration diagram in Figure 8.

Similar to the power generating apparatus according to the aforementioned first embodiment, the power generating apparatus according to the second embodiment, includes the heat generating means 10 including the container 1, the pair of opposed electrodes 2 consisting of the first electrode 2a and the second electrode 2b, and the heat generating body 3 formed of the silicon powder 3a and the carbon powder 3b, and includes the thermoelectric means 20. The power generating apparatus further includes heat storing means 30 that is disposed between the heat generating means 10 and the thermoelectric means 20 and that stores heat generated by heat generation performed by the heat generating means 10, as illustrated in Figure 8 (a) .

Also, the shape of the heat generating means 10 is not limited to a particular shape, but may be a flat plate-like shape, as illustrated in Figure 8(a), or may be a cylindrical shape, as illustrated in Figure 8(b), for example.

The heat storing means 30 functions as a thermally conductive layer (intermediate layer) that is interposed between the heat generating means 10 and the thermoelectric means 20 so as to exchange heat energy. The material forming the heat storing means 30 is not limited to a particular material, but flat metal is preferably used therefor. A copper plate may be used therefor in view of handling easiness. Alternatively, a heat pipe, ceramic concrete, a mineral pump, a silicon grease, or the like may be used, for example. In addition, an earthware such as a ceramic tile, or a brick having high heat-storage performance such as a heat storage brick or a refractory brick may be used. Smooth use thereof can be performed in cold climate areas where such bricks are commonly used.

With this configuration, the heat storing means 30 temporarily holds heat generated by heat generation performed by the heat generating means 10. Accordingly, heat energy variation can be allowed (buffered), and, even when excessive heat energy is generated by heat generation performed by the heat generating means 10, the heat energy does not need to be discharged as unnecessary energy but is temporarily held in the heat storing means 30 so as to be usable. Accordingly, power can be stably generated by the thermoelectric means 20 with higher energy efficiency. In addition, the heat storing means 30 can be used as a backup heat source even when power from the external power 100 is interrupted because the heat storing means 30 holds heat energy for a certain time. Accordingly, power can be continuously generated even when the power source is interrupted.

In addition, also when heat generation performed by the heat generating means 10 suddenly changes or stops, the operation of the thermoelectric means 20 can be continued with use of the heat energy held in the heat storing means 30, whereby the operation stability can also be enhanced. Moreover, the heat storing means 30 uniformizes heat generated by heat generation performed by the heat generating means 10 and holds the heat. Thus, stable supply can be performed while the temperature (optimum temperature) for optimizing (maximizing) the power conversion efficiency of the thermoelectric means 20 is maintained. Power can be generated under the condition where the heat generating performance of the thermoelectric means 20 is optimized. Accordingly, power can be stably and continuously generated by the thermoelectric means 20 with higher energy efficiency.

Furthermore, as a result, the heat storing means 30 diffuses and supplies, to the thermoelectric means 20, heat generated by heat generation performed by the heat generating means 10. For example, for the thermoelectric means 20 that is formed of Seebeck elements or Thomson elements, heat energy supplied from the heat generating means 10 can be diffused and supplied to each of the Seebeck elements or the Thomson elements forming the thermoelectric means 20 such that the heat energy becomes lower than the upper limit heat absorbing temperature of the Seebeck elements or the Thomson elements. Accordingly, heat energy can be exchanged with efficiency within the allowance range of the Seebeck elements or Thomson elements so as to sufficiently correspond to the heat absorbing performance of the elements. Accordingly, the performance of the Seebeck elements or Thomson elements can be stably and sufficiently exerted.

Since the heat storing means 30 diffuses and supplies, to the thermoelectric means 20, heat generated by heat generation performed by the heat generating means 10, as described above, the thermoelectric means 20 constantly receives, at the opposing surface 21, uniform heat energy within the operable range. Accordingly, more stable power can be continuously generated.

### (Third Embodiment)

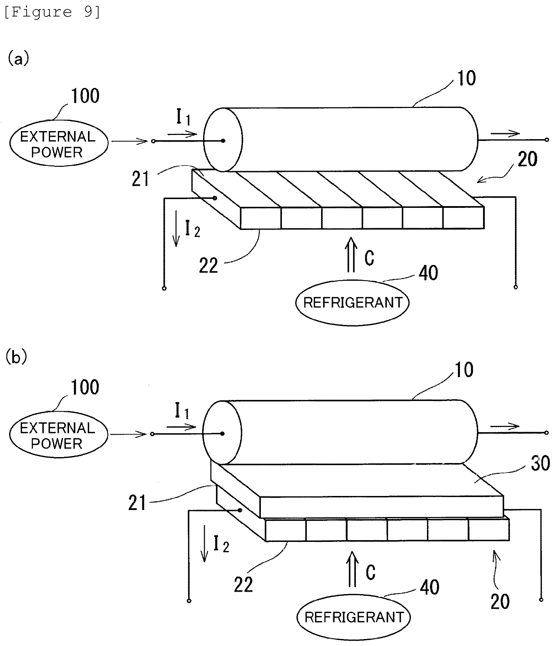

A power generating apparatus according to a third embodiment of the present application will be described in accordance with the configuration diagrams in Figure 9.

Similar to the power generating apparatus according to the aforementioned first embodiment, the power generating apparatus according to the third embodiment includes the heat generating means 10 including the container 1, the pair of opposed electrodes 2 consisting of the first electrode 2a and the second electrode 2b, and the heat generating body 3 formed from the silicon powder 3a and the carbon powder 3b, and includes the thermoelectric means 20. As illustrated in Figure 9(a), the power generating apparatus is configured to further include cooling means 40 which is formed of a fluid having cooling performance, which is disposed so as to be close to the rear surface 22 of the thermoelectric means 20, and which cools the rear surface 22 of the thermoelectric means 20.

As the cooling means 40, water or outside air which is naturally generated, or a device having cooling performance such as a cooler or a heat pipe can be widely used. For example, in cold climate areas, etc., where snow and ice always exist, the power generating apparatus according to the present embodiment only needs to be placed or embedded in the snow or ice. Thus, the cooling means 40 can act excellently.

Since the cooling means 40 which cools the rear surface 22 of the thermoelectric means 20 is included, the thermoelectric means 20 receives, at the opposing surface 21, heat generated by heat generation performed by the heat generating means 10, while the cooling means 40 cools the rear surface 22 of the thermoelectric means 20. Accordingly, a large temperature difference is generated in the thermoelectric means 20 so that larger power can be generated by the thermoelectric means 20.

Note that, as a matter of course, the power generating apparatus according to the present embodiment also may be configured to include the heat storing means 30, as in the power generating apparatus according to the second embodiment, as illustrated in Figure 9(b).

### (Fourth Embodiment)

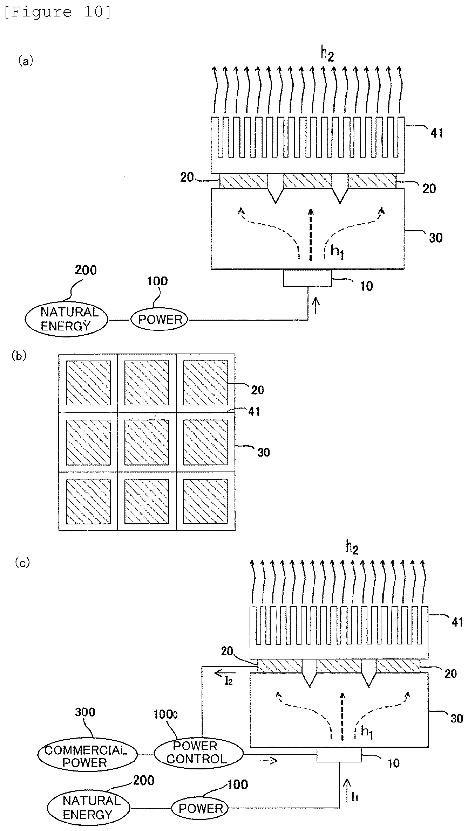

A power generating apparatus according to a fourth embodiment of the present application will be described in accordance with the configuration diagrams in Figures 10 to 16.

Similar to the power generating apparatus according to the aforementioned fourth embodiment, the power generating apparatus according to the fourth embodiment includes the heat generating means 10 including the container 1, the pair of opposed electrodes 2 consisting of the first electrode 2a and the second electrode 2b, and the heat generating body 3 formed from the silicon powder 3a and the carbon powder 3b, the thermoelectric means 20, and the cooling means 40. Furthermore, as illustrated in Figure 10(a), the power generating apparatus is configured such that the external power 100 is power derived from the natural energy 200.

The natural energy 200 is not limited to particular energy, but water power energy, wind power energy, or solar energy can be adopted therefor. As power generation methods for generating the external power 100 from these types of energy, water power generation, wind power generation, and solar power generation can be used. Regarding water power energy and wind power energy, power is generated by a power generator 102 with use of energy that has been generated by a turbine 101 being rotated by the natural energy 200 so that external power 100 can be obtained, as illustrated in Figure 10(a), for example. In this way, an AC power source is generated from the natural energy 200, and is used as the external power 100 as it is. Solar energy as another natural energy 200 generates a DC power source. Thus, after AC conversion to an AC power source is performed thereon, the AC power source can be used as the external power 100, as in the aforementioned case.

When the external power 100 derived from the natural energy 200 is used, a switching mechanism serving as a thermostat may be provided between the external power 100 and the heat generating means 10. When excessive power source supply of the natural energy 200 the power source supply amount of which is unstable is generated or when the amount of heat generated by the heat generating means 10 is made excessively large by the switching mechanism, the switching mechanism is controlled to be off (turned off) so that the power source supply amount from the external power 100 is controlled. Accordingly, heat generation can be stably and continuously performed by the heat generating means 10.

The external power 100 is power derived from the natural energy 200, as described above. Thus, even when the natural energy 200 the power generation amount of which is low and unstable is used as a power source because the heat generating efficiency of the heat generating means is very high, the heat generating means 10 can stably perform heat generation, that is, power can be stably and continuously generated by the thermoelectric means 20 with use of the natural energy. Accordingly, stable power is taken out from the external power 100 that has been obtained with use of the natural energy 200. Thus, the efficient use of the natural energy 200 can be performed.

In a more preferable configuration, the external power 100 is supplied by power derived from the natural energy 200 based on a fluid, and the cooling means 40 is formed of the fluid. The cooling means 40 is still more preferably formed of the fluid that has cooling performance.

As the fluid forming the cooling means 40 is not limited to a particular fluid, and both gas and a liquid can be used therefor. That is, an air flow may be used, or a water flow may be used therefor. For example, as illustrated in Figure 10(a), when water power energy is used as the natural energy 200, water which is the fluid used to cause water power by means of the turbine 101 can be used. When wind power energy is used as the natural energy 200, wind (an air flow) which is the gas used to cause wind power by means of the turbine 101 can be used.

That is, the external power 100 is supplied by power derived from the natural energy 200 based on dynamic energy of the fluid, and the cooling means 40 cools the rear surface of the thermoelectric means with use of the static energy of the fluid. For example, when wind power energy is used as the natural energy 200, the fluid is an air flow (wind), the dynamic energy of the fluid is the fluid flowing force (i.e., wind power), the static energy of the fluid is the temperature of the air flow (wind). For example, when water power energy is used as the natural energy 200, the fluid is a water flow (water), the dynamic energy of the fluid is the water flowing force (i.e., water power), and the static energy of the fluid is the temperature of a water flow (water). In any case, since the static energy of the fluid has high cooling performance (having temperature lower than the surrounding temperature), the fluid functions as the cooling means 40 to actively cool the rear surface 22 of the thermoelectric means 20. Accordingly, a large temperature difference is generated in the thermoelectric means 20, and large power can be stably generated by the temperature difference.

Since the fluid forming the cooling means 40 and having cooling performance is identical to the fluid for causing the natural energy 200, a fluid to be used for power generation using the natural energy 200 is also returned to the power generating apparatus according to the present embodiment and is reused so that a larger temperature difference is generated in the thermoelectric means 20. Accordingly, efficient use of natural energy can be performed with higher efficiency, while power can be stably and continuously generated by the thermoelectric means 20.

Since the power generating apparatus according to the present embodiment can also efficiently use a fluid used for power generation performed by the natural energy 200, the power generating apparatus may be used in a form (a built-in form) of having been integrally incorporated as a part of a power generation facility.

Note that, as a matter of course, also in the power generating apparatus according to the present embodiment, the configuration including the heat storing means 30 as in the power generating apparatus according to the second embodiment can be adopted, as illustrated in Figure 10(b).

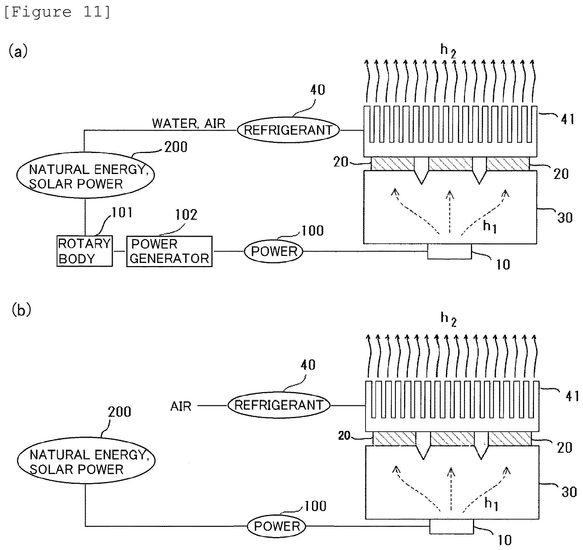

As the configuration including the heat storing means 30, a heat dissipator (e.g., a heat sink) may be incorporated as the cooling means 40 to cool the thermoelectric means 20, for example. A heat sink 41 can be placed together with the thermoelectric means 20 on the upper surface of the heat storing means 30, as illustrated in Figure 11(a), for example. When viewed from the upper surface of the heat storing means 30, the plurality of thermoelectric means 20 and the heat sink 41 are placed on the upper surface of the heat storing means 30, as illustrated in Figure 11(b).

With this configuration, heat energy h₁ generated by heat generation performed by the heat generating means 10 spreads over the heat storing means 30 while being diffused in the heat storing means 30 so that the heat energy h₁ is uniformly transferred to the thermoelectric means 20 disposed on the upper surface and the thermoelectric means 20 is cooled by the heat sink 41. Accordingly, a large capacity of power can be more efficiently generated by the temperature difference in the thermoelectric means 20.

In addition, heat energy h₂ is dissipated by the heat sink 41 to the outside. Accordingly, the heat energy h₂ can be used as various heat sources.

With this configuration, the heat energy h₁ generated by heat generation performed by the heat generating means 10 spreads over the heat storing means 30 while being diffused in the heat storing means 30 so that the heat energy h₁ is uniformly transferred to the thermoelectric means 20 disposed on the upper surface and the thermoelectric means 20 is cooled from the heat sink 41. Accordingly, a large capacity of power can be more efficiently generated by the temperature difference in the thermoelectric means 20.

The shape of the heat sink 41 is not limited to a particular shape, but the heat sink 41 is formed of multiple fins (plates), multiple needles, or bellows. The material of the heat sink 41 is not limited to a particular material, but the heat sink 41 is preferably made from metal. For example, aluminum, iron, or copper may be used therefor. Alternatively, nonmetal such as an earthware or brick may be used.

Moreover, as illustrated in Figure 11(c), a part of power (current I₂) generated by the thermoelectric means 20 can be returned to serve as the power source for the heat generating means 10. In this case, the external power 100 can be controlled by current and voltage control in which power to be supplied to the heat generating means 10 can be turned on/off by switching. For example, as illustrated in Figure 11(c), power control 100c to control power to be supplied to the heat generating means 10 by connection to a commercial power 300 which is used as a backup power source is provided. Accordingly, when the power (current I₁) from the external power 100 is large, control to cause a small amount of power, as a part of the power (current I₂) generated by the thermoelectric means 20, to return to serve as the power source for the heat generating means 10, can be performed by the power control 100c. When the power (current I₁) from the external power 100 is small, the power control 100c can be performed to perform optimum control in which a smaller amount of power is controlled to be returned, as a part (current I₂) of the power generated by the thermoelectric means 20, so as to serve as the power source for the heat generating means 10.

With this configuration, due to the high heat generating efficiency of the heat generating means 10, power supplied from the external power 100 is set to be off through switching after the initial heating performed by the heat generating means 10, and thereafter, heat energy is stored in the heat storing means 30. Accordingly, a part of power generated by the thermoelectric means 20 can be used as power for the heat generating means 10, and power generation can be efficiently performed while saving energy without constantly using power from the external power 100.

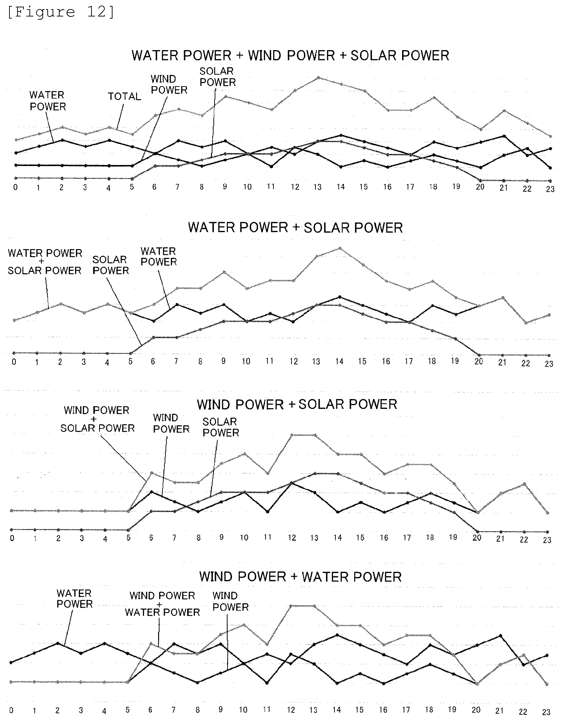

When wind power or water power is used as the natural energy 200, for example, the cooling means 40 is formed with use of wind power or water power which is a fluid used in power generation using the natural energy 200 so that efficient cooling is performed, as shown in Figure 12(a), for example. When solar light is used as the natural energy 200, for example, the cooling means 40 is formed with use of air so that efficient cooling is performed, as illustrated in Figure 12(b), for example.

Moreover, in the power generating apparatus according to the present embodiment, only the external power 100 derived from one type of the natural energy 200 may be used. However, a plurality of types of the natural energy 200 may be simultaneously used such that the external power 100 generated from the various types of the natural energy 200 can be used in combination (irrespective of whether the external power 100 is an AC power source or a DC power source).

For example, when the plurality of types of the natural energy 200 are all configured to generate AC power sources, the plurality of types of the natural energy 200 can be used as one AC power source as the whole. When the plurality of types of the natural energy 200 are all configured to generate DC power sources, the plurality of types of the natural energy 200 can be used as one DC power source as the whole. When the plurality of types of the natural energy 200 include both energy to generate an AC power source and energy to generate a DC power source, the plurality of types of the natural energy 200 can be used as a hybrid (AC/DC hybrid) of the AC power source and the DC power source.

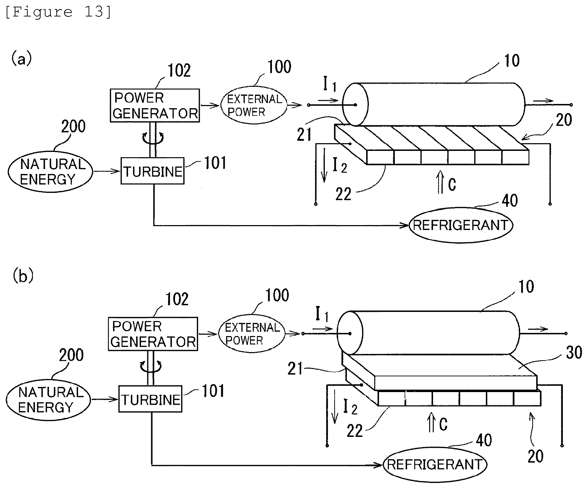

When water power energy which generates an AC power source and solar energy which generates a DC power source are simultaneously used as the natural energy 200, for example, no DC power derived from the solar energy is generated during a midnight time zone (e.g., from 0000 to 0500 o'clock) because there is no solar light during this time zone, while AC power derived from the water power energy is generated by water power, as shown in Figure 13. Thus, the total power amount gradually increases with a lapse of time.

Next, during the daytime zone (e.g., from 0500 to 2000 o'clock), DC power derived from solar energy is generated by solar light and AC power derived from water power energy is also generated. Thus, the total power amount increases because the DC power and the AC power are overlappingly accumulated.

During the night time zone (e.g., 20 to 24 2000 to 2400 o'clock), no DC power derived from solar energy is generated because there is no sun light during this time zone. However, heat energy stored during the daytime zone in the heat generating means 10 remains. AC power derived from water power energy is combined therewith, and thus, the total power amount stably changes with a lapse of time without involving a sudden drop.

Thereafter, the total power amount stably changes with a lapse of time as before due to contribution made by the stored heat energy buffered in the heat generating means 10. When the aforementioned heat storing means 30 is further added, the heat storing efficiency in the daytime zone is further enhanced. Thus, the total power amount more stably changes with a lapse of time.

As described above, stable power generation can be performed with an unprecedent simple configuration in which, due to the highly efficient heat generation amount and the heat storage amount exerted by the heat generating means 10, a hybrid (AC/DC hybrid) of the AC power source and the DC power source can be formed from the plurality of types of the natural energy 200 without requiring any inverter. As the natural energy 200 which causes DC power, tidal power may be used. Irrespective of tides, stable power generation can be performed with the hybrid (AC/DC hybrid) of the AC power source and the DC power source.

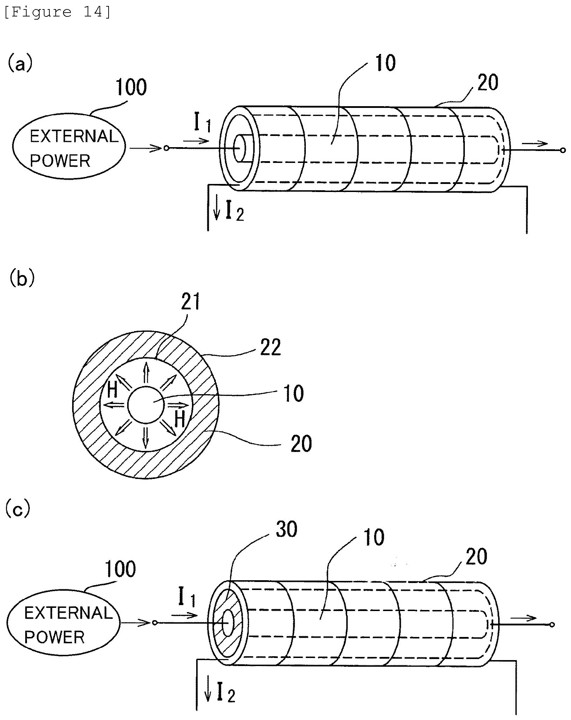

In addition, as illustrated in Figure 14, in the power generating apparatus according to the present embodiment, the heat sinks 41 are disposed so as to be opposed to each other, and a space between the opposed heat sinks 41 may be cooled by use of a cooling fan 103. Figure 14(a) illustrates the cooling means 40 using air cooling in wind power generation or solar power generation. Figure 14(b) illustrates the cooling means 40 using water cooling in water power generation.

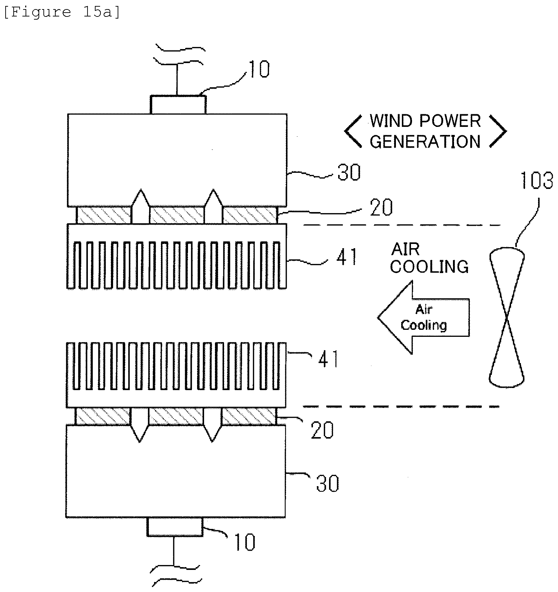

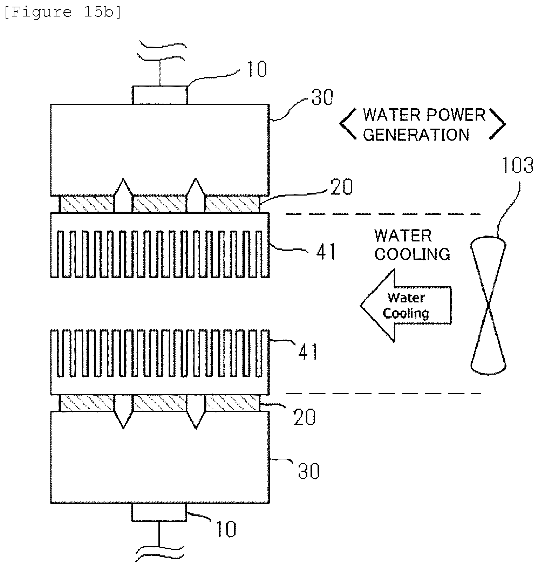

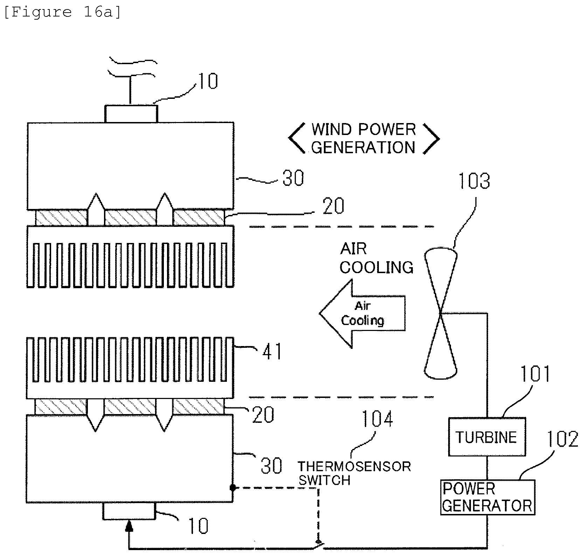

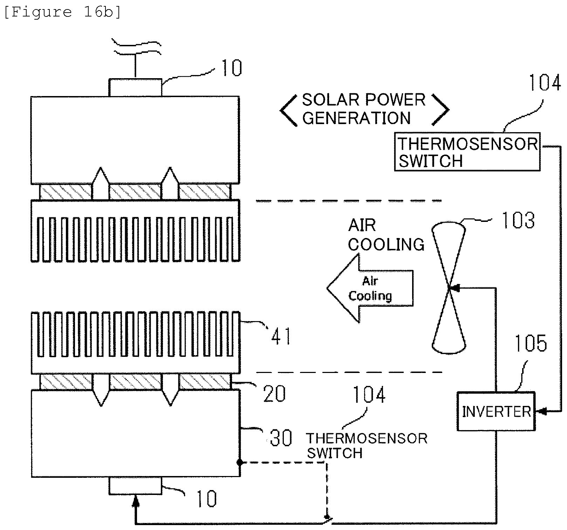

Further, in wind power generation, the aforementioned air cooling can be performed by the turbine 101 provided to the power generator 102, as illustrated in Figure 15(a). Since the thermosensor switch 104 which is used when power is supplied from the power generator 102 to the heat generating means 10 is provided, fixed temperature control can be performed. In solar power generation, the aforementioned air cooling can be performed by an inverter 105 provided to a solar panel 104, as illustrated in Figure 15(b). In water power generation, the aforementioned air cooling can be performed by the turbine 101 provided to the power generator 102, as illustrated in Figure 16(a). By the aforementioned thermosensor switch 104, control to make temperature fixed can be performed with high accuracy, as illustrated in Figure 16(b).

### (Fifth Embodiment)

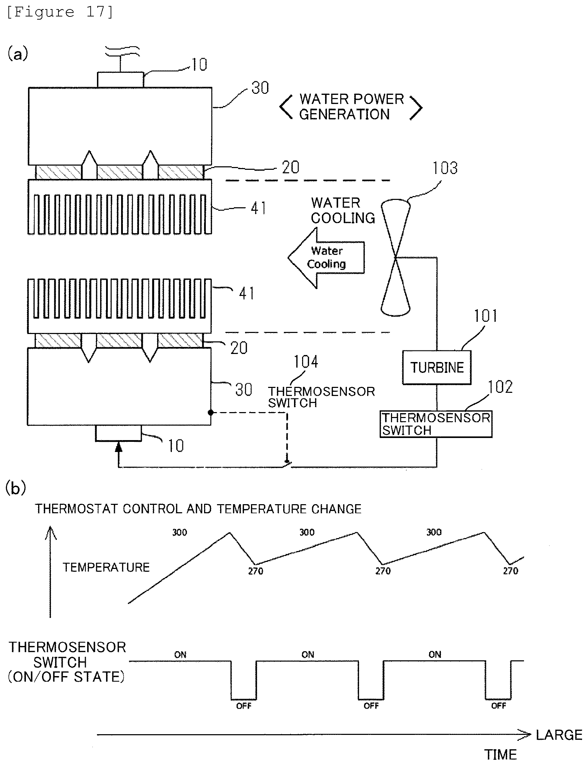

Note that, in the aforementioned embodiments, the flat plate-like thermoelectric means 20 is disposed so as to be close to the heat generating means 10. However, the arrangement is not limited to these embodiments. In a fifth embodiment, as illustrated in Figure 17(a), the heat generating means 10 may have a cylindrical shape while the thermoelectric means 20 may be formed to have a tubular shape and be configured to surround the heat generating means 10.

With this configuration, as illustrated in Figure 17(b), the heat energy (H) emitted from the heat generating means 10 to the surrounding area is completely received by the thermoelectric means 20. Thus, the temperature difference between the opposing surface 21 and the rear surface 22 of the thermoelectric means 20 is further increased so that power can be more efficiently generated by the thermoelectric means 20.

Furthermore, as illustrated in Figure 17(c), the heat storing means 30 having been described in the second embodiment may be interposed between the heat generating means 10 and the thermoelectric means 20. With this configuration, since the heat storing means 30 encloses the circumference of the heat generating means 10, the heat energy (H) generated by heat generation performed by the heat generating means 10 can be completely held so that all the heat energy (H) generated by the heat generating means 10 is temporarily held in the heat storing means 30 with no loss so as to be able to be used. Accordingly, power can be stably generated by the thermoelectric means 20 with higher energy efficiency.

As described above, as one example of the power generating apparatus in which heat is generated by the heat generating means 10 and the outer portion thereof is cooled by a fluid, a configuration in which a partition is provided in a casing having a cylindrical or rectangular parallelepiped body, the heat generating means 10 is stored in the partition, and the cooling fluid is caused to flow to the outer part of the partition can be adopted.

### (Sixth Embodiment)

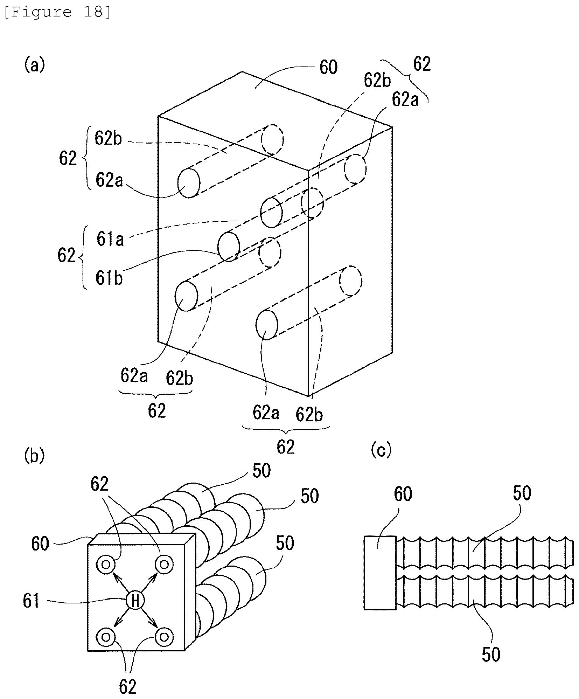

A heating apparatus can be configured by using the heat generating device according to any one of the aforementioned first to third embodiments. The heating apparatus according to a sixth embodiment of the present application will be described in accordance with the configuration diagrams in Figure 18.

As illustrated in Figure 18, the heating apparatus according to the sixth embodiment is configured to include the heat generating means 10 which is formed of the heat generating device, heat pipes 50 which each have a longitudinal shape and which generate heat upon supply of external power from the outside to the opposed electrodes, a heat storing part 60 which is made from a metal ingot, and in which a housing portion 61 formed of a through hole 61b (the open end of this hole is defined as an opening portion 61a) in close contact with at least a longitudinal surface of the heat generating means 10 is formed in the metal ingot, and holding portions 62 formed of through holes 62b (the open end of each of these holes is defined as an opening portion 62a) being disposed at symmetric positions around the arrangement position of the housing portion 61 and holding the heat pipes 50 while being in close contact with longitudinal surfaces of the heat pipes 50, are formed in the metal ingot, and control means which controls heat generation start and heat generation stop of the heat generating means 10 such that the thermal energy stored in the heat storing part 60 does not fall below energy dissipated by the heat pipes 50.

The shape of the heat generating means 10 is not limited to a particular shape, but may be a cylindrical shape, for example. Alternatively, a rectangular parallelepiped shape may be adopted therefor.

The shape of the heat pipe 50 is not limited to a particular shape as long as the shape is a longitudinal shape. For example, a cylindrical body can be adopted therefor. Alternatively, a rectangular parallelepiped shape may be adopted therefor.

As illustrated in Figure 18(a), the heat storing part 60 is formed of a metal ingot, and includes, at the center, a housing portion 61 formed of a through hole 61b and an opening portion 61a, and includes, at symmetrical positions around the arrangement position of the housing portion 61, the holding portions 62 which each include a through hole 62b and an opening portion 62b.

The metal ingot is not limited to a particular metal ingot, but iron, copper, an aluminum alloy, or stainless can be used therefor, for example. A metal ingot formed from an aluminum alloy (a so-called aluminum block) is more preferably used therefor. Due to high latent heat property of the aluminum alloy (solidification latent heat is 394 J/g at 700°C), a simple configuration including heat generation performed by the heat generating means 10, heat storage performed by the heat storing part 60 (e.g., an aluminum block), heat dissipation performed by the heat pipe 50 causes functions of the advantages of the components including the configured heat generating means 10, the heat storing part 60 (e.g., an aluminum block), and the heat pipes 50. Thus, the present heating apparatus can exert a significantly excellent heat retaining property. Moreover, the metal ingot may be warmed with a thermal insulating material (e.g., a cork material). In this case, a higher heat retaining efficient can be maintained.

In addition, as illustrated in Figures 18(b) and 18(c), the heat pipes 50 are fixed and held by the holding portions 62, respectively. The heat pipes 50 each have a hollow inner part, and transfer heat by fluidizing working gas in the inner part. Moreover, in order to obtain a higher heat dissipating property, heat dissipation is preferably performed by use of fins such as aluminum fins around the heat pipes 50.

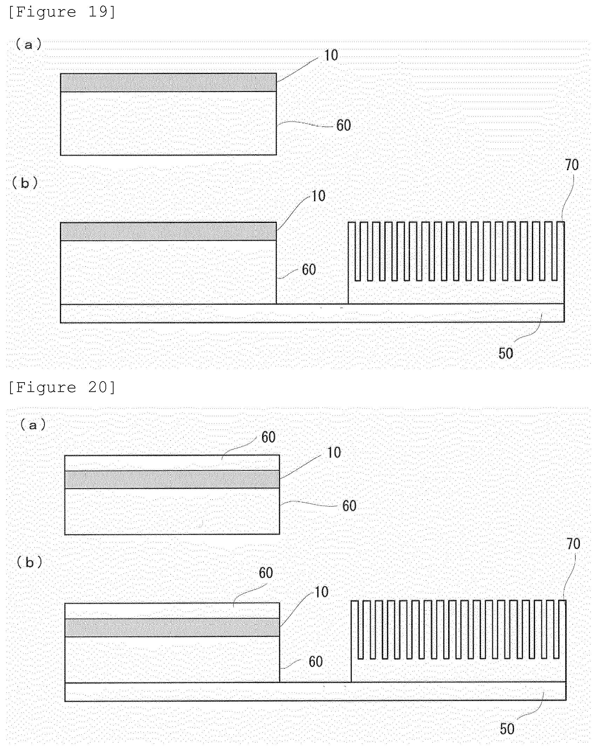

For example, the heat generating means 10, which is illustrated in Figure 19(a) as a schematic configuration diagram, and fixed to the heat storing part 60 (e.g., an aluminum block) can be connected to the heat pipes 50 and the fins 70 can be provided around the heat pipes 50, as illustrated in Figure 19(b).

As a matter of course, also when the heat generating means 10 is housed inside the heat storing part 60 (e.g., an aluminum block), as illustrated in Figure 20(a), the heat generating means 10 and the heat storing part 60 (e.g., an aluminum block) can be connected to the heat pipes 50 and the fins 70 can be provided around the heat pipes 50, as illustrated in Figure 20(b).

The material of the fins 70 is not limited to a particular material, but iron, copper, an aluminum alloy, or stainless can be used therefor. Fins (so-called aluminum fins) formed from aluminum alloys are more preferably used.

Moreover, when the weight of component metal (e.g., an aluminum alloy) in the heat storing part 60 (e.g., an aluminum block) is increased, the amount of latent heat in the heat storing part 60 (e.g., an aluminum block) is increased. Therefore, the heat dissipation time can be lengthened. Furthermore, since the heat emission amount can be controlled on the basis of the dimension of the total length of the heat pipes 50 and the fins 70, the heat emission amount can be freely controlled on the basis of the volume of a space. Thus, a heating apparatus can be easily designed.

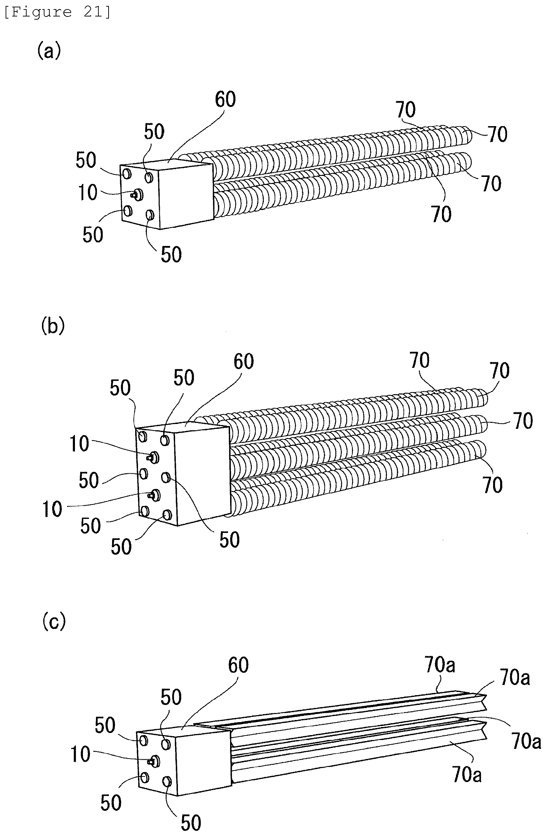

The number of the heat generating means 10 and the number of the heat pipes 50 can be freely designed in light of the volume of a space therefor, etc. For example, as illustrated in Figure 21(a), the apparatus can be formed of one heat generating means 10 and four heat pipes 50 and four fins 70 surrounding the heat generating means 10. Alternatively, as illustrated in Figure 21(b), the apparatus may be formed of two heat generating means 10 and eight heat pipes 50 and eight fins 70 surrounding the heat generating means 10. In addition, flat plate-shaped air fins 70a can be used as the fins 70, as illustrated in Figure 21(c).

When power application from the outside to the heat generating means 10 is started with the aforementioned configuration, and the heat generating means 10 generates power, heat energy generated by the heat generating means 10 is actively stored in the heat storing part 60 (e.g., an aluminum block) to slowly transfer the heat energy to the heat pipes 50. Accordingly, heat dissipation is stably performed by the heat pipes 50 to which the heat energy has been stably supplied, and heat dissipation to the outside is promoted by the fins 70, so that the heat energy is efficiently diffused to the outside. Thus, more efficient heating efficiency can be exerted.

Also when the power application from the outside to the heat generating means 10 is sequentially stopped to stop the heat generation performed by the heat generating means 10, the heat energy is slowly and continuously transferred to the heat pipes 50 through the heat storing part 60 (e.g., an aluminum block) having stored therein the heat energy from the heat generating means 10. Accordingly, heat dissipation is continuously performed by the heat pipes 50 to which the heat energy has been stably supplied, and heat dissipation is promoted by the fins 70, so that the heat energy is efficiently diffused to the outside. Thus, more efficient heating efficiency can be exerted while more power is saved.

As described above, power application from the outside to the heat generating means 10 is repeatedly started and stopped, whereby a power-saving and efficient heating apparatus can be implemented.

That is, the control means appropriately controls start and stop of heat generation performed by the heat generating means 10, whereby a more power-saving and efficient heating apparatus can be implemented.

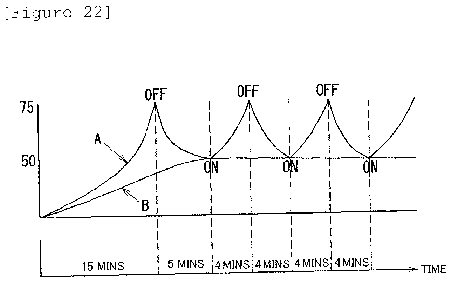

The control means controls heat generation start and heat generation stop of the heat generating means 10 such that thermal energy stored in the heat storing part 60 does not fall below energy dissipated by the heat pipes 50. Figure 22 shows an explanatory diagram of the result of control performed by the control means based on the measurement values. The control means performs control to repeat an ON operation and an OFF operation such that, when the heat generation temperature reaches an upper limit threshold temperature (e.g., about 70°C) by rising with time by heat generation performed by the heat generating means 10, the heat generation of the heat generating means 10 is stopped (OFF operation), and then, when the heat generation temperature reaches a lower limit threshold temperature (e.g., about 50°C), heat generation to be performed by the heat generating means 10 is started (ON operation), as indicated by a curved line A shown in Figure 22, for example. The time interval between the ON operation and the OFF operation may be set to 4 to 5 minutes, as shown in Figure 22. As a result, as indicated by a curved line B, energy dissipated by the heat pipes 50 is fixed, and the dissipation temperature is fixed (e.g., about 55°C). By the heat generating means 10 which can increase the temperature to about 300°C with external power of about 50 W, that is, can obtain high heat energy with significantly low power, as described in the aforementioned first embodiment, a heating apparatus having significantly excellent power saving performance is formed in which sufficient substantially necessary external power is high (e.g., 80 W/h) only at an initial temperature rise time, and thereafter, weak power (e.g., 25 W/h) is sufficient therefor due to the aforementioned control to repeat the ON operation and the OFF operation.

When the natural energy 200 having been described in the fourth embodiment is used as the power source (external power from the outside) for the heat generating means 10, a power-saving heating system having a low environmental load and high heating performance is formed independently of a commercial power source. Use of the heating system including but not limited to uses including the inside of a sauna, a greenhouse, a building, a house, or a log cabin, various devices or vehicles or equipment and block heaters or industrial equipment such as a die, requiring to be heated, for example.

As described above, in the sixth embodiment, only by one increase of the temperature of the heat generating means 10 due to the excellent heat generation efficiency of the heat generating means 10, the temperature can be maintained by the heat storing part 60 for a long time after the increase, under control by the control means. Thus, dissipated heat energy dissipated by heat conduction of the heat pipes 50 is fixed, so that heating can be stably performed for a long time with a small amount of power.

Note that, in the aforementioned heat generating means 10, the heat generating means 10 may have a configuration in which the housing portion 61 and the holding portion 62 are formed so as to be each equally divided into two. With this configuration, the heat generating means 10 can stably and uniformly supply a heat source for the heat pipes 50. Accordingly, dissipated heat energy dissipated by heat conduction of the heat pipes 50 can be fixed, and further, heating can be stably performed for a long time.

### (Seventh Embodiment)

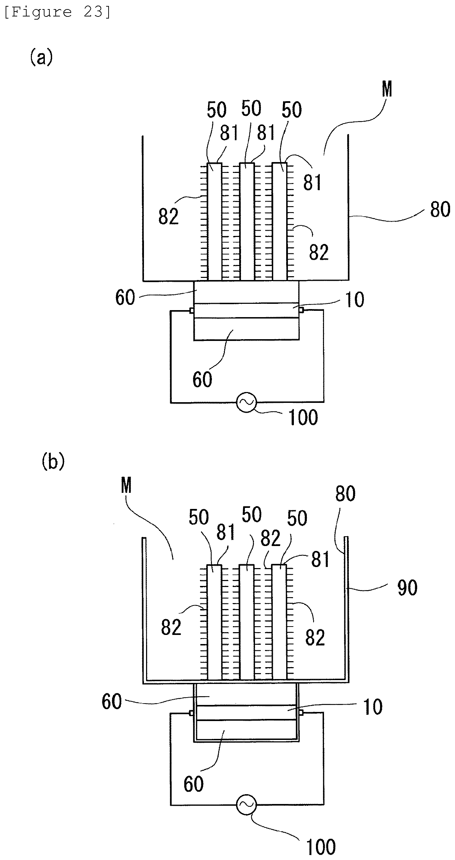

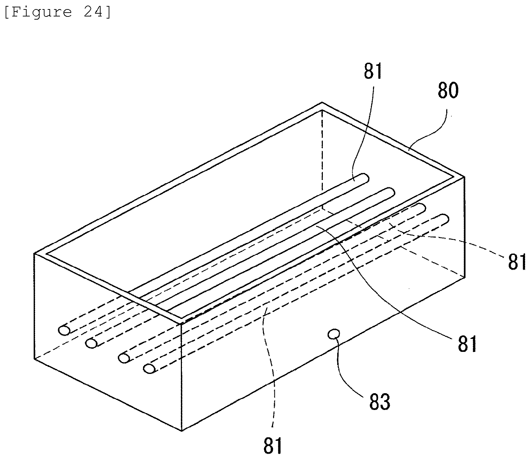

A warming apparatus can be configured by use of the heat generating device according to any one of the aforementioned first to third embodiments. The warming apparatus according to a seventh embodiment of the present application will be described in accordance with the configuration diagrams in Figures 23 and 24.

As illustrated in Figure 23(a), the warming apparatus according to the seventh embodiment includes the heating apparatus including the heat generating means 10 and the heat storing part 60, and a housing container 80 in which heat pipe accommodating portions 81 accommodating the heat pipes 50 are provided and which non-airtightly houses a medium M made of a liquid or gas, and is for warming or vaporizing the medium M in the housing container 80.

Outer side surfaces of the heat pipe accommodating portions 81 in the housing container 80 may be left as it is, but fins 82 are preferably provided thereto in view of promotion of heat diffusion.

In addition, the housing container 80 may house the medium M while being in an airtight state.

With this configuration, the medium in the container is warmed or vaporized with use of heat stably dissipated by the heat pipes 50. In the case where the medium M is a liquid, the liquid can be warmed with higher heat retaining property. In the case where the medium M is gas, the liquid can be quickly vaporized after being taken into the housing container 80.

In the case where the medium M is a liquid (e.g., water), as a small-sized example, this configuration can be used to warm soup dishes such as oden soup which is regularly provided in shops such as convenience stores or restaurants, for example, due to the high heat retaining property. As a larger-sized example, this configuration can be applied to wide use, such as heated pools or public bathhouses, for maintaining water temperature. For example, in the case where the medium M is gas, when a liquid comes into contact with the heat pipes 50, vapor is immediately generated by the quick vaporizing property. Thus, use as a vapor generator or a humidifier is possible.

As illustrated in Figure 23(b), the warming apparatus according to the seventh embodiment may be covered with a thermal insulating material 90. A cork material may be used as the thermal insulating material 90. As a result of covering with the thermal insulating material 90, as described above, the heat retaining property of the inside of the housing container 80 is further enhanced. Accordingly, a warming apparatus having a higher heat retaining property can be implemented.

Note that the warming apparatus according to the seventh embodiment may have a vertically placed shape in which the heat pipes 50 are standing in columnar shapes, as described above, but is not limited to this. A horizontally placed shape in which the heat pipes 50 are horizontally arranged may be adopted. In the case where the medium M is water, for example, when being configured to have the horizontally placed shape, as illustrated in Figure 24, for example, the present warming apparatus can be configured as a water tank to be able to exert the excellent heat retaining effect. In addition, a drain hole 83 may be provided in a side surface of the present warming apparatus according to use.

The outer surface of the heat pipe accommodating portion 81 in the housing container 80 may be left as it is. However, the fins 82 may be provided thereto in view of promotion of thermal diffusion, as described above. The heat retaining property of the inside of the container is further increased, and thus, a warming apparatus having a higher heat retaining property is implemented.

Hereinafter, examples will be given in order to further clarify the features of the present invention, but the present invention is not restricted by these examples.

### (Example 1)

In accordance with the aforementioned first embodiment, a flat plate-like heat generating body having, as illustrated in Figure 1, a rectangular parallelepiped shape the height of which is 12 mm and the entire longitudinal length and the entire lateral length of which are each 170 mm was prepared, the heat generating body is placed on a Seebeck element having the same size, and thereby, a power generating apparatus sample was produced. The casing of a container for the heat generating body was made from ceramic, and copper was used for opposed electrodes in the casing. Silicon powder which was 30 to 60 µm and used regenerated silicon and carbon powder which was 30 to 60 µm and was discarded during battery production of a secondary battery, etc., were housed in the casing. The casing was closed with a plastic-made cap, and the outer portion of the cap was fixed with a nut. Constant power was applied to the sample for 30 minutes.

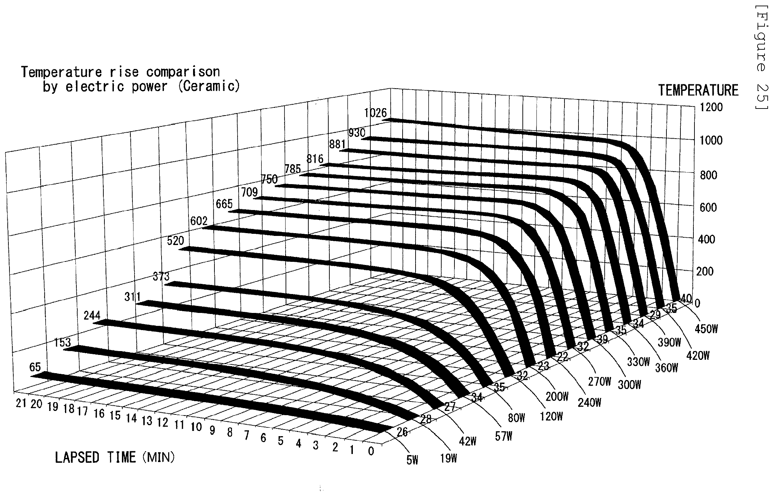

Regarding the result obtained by applying voltage to the aforementioned power generating apparatus sample for 30 minutes, the result of time-based temperature rise is shown on the basis of a power amount (W) in Figure 25. From the obtained result, from Figure 25, the steep temperature rise was confirmed within 1 or 2 minutes, and it was also confirmed that the temperature having risen was not lowered and certain temperature was maintained even after a lapse of 30 minutes. Moreover, it was confirmed that the temperature having risen reached 1000°C. In addition, from the obtained result, it was confirmed that the temperature change slightly fluctuated at a point where the lapsed time is around 8 to 12 minutes in Figure 25. Therefore, during this time zone, it is conjectured that a change in the mixed state of the silicon powder and the carbon powder was generated. The change in the mixed state of the powder generated the change of the electrical conductivity and heat conductivity. Thus, it was confirmed that a phase of the temperature rise was shifted to a phase of maintaining the certain temperature. It was confirmed that the heat energy from the heat generating body from which the very high temperature state was obtained was received by the Seebeck element, whereby power was stably generated for a long time.

### (Example 2)

In accordance with the aforementioned sixth embodiment, a flat plate-like heat generating body having, as illustrated in Figure 21(a), a rectangular parallelepiped shape the height of which is 12 mm and the entire longitudinal length and the entire lateral length of which are each 170 mm was prepared, and the heat generating body was housed, together with four heat pipes, in an aluminum block (aluminum alloy) having width 100 mm × height 60 mm × depth 110 mm and having a weight of 2 kg, and thereby a sample of a heating apparatus thus configured was produced. Respective air fins were attached to the four heat pipes. A casing of a container for the heat generating body was made from ceramic, and copper was used for opposed electrodes in the casing. Silicon powder of 30 to 150 µm and carbon powder of 30 to 150 µm were housed in the casing. The casing was closed with a plastic-made cap, and the outer portion of the cap was fixed with a nut. As samples, three types of samples including a sample formed of the heat generating body only, a sample formed of the heat generating body and the aluminum block, and a sample formed of the heat generating body, the aluminum block, the heat pipes, and air fins were produced. Power of 200 W was applied to these samples, the supply of power was stopped at the time point when the temperature reached 200°C, and 375-minutes measurement was carried out.

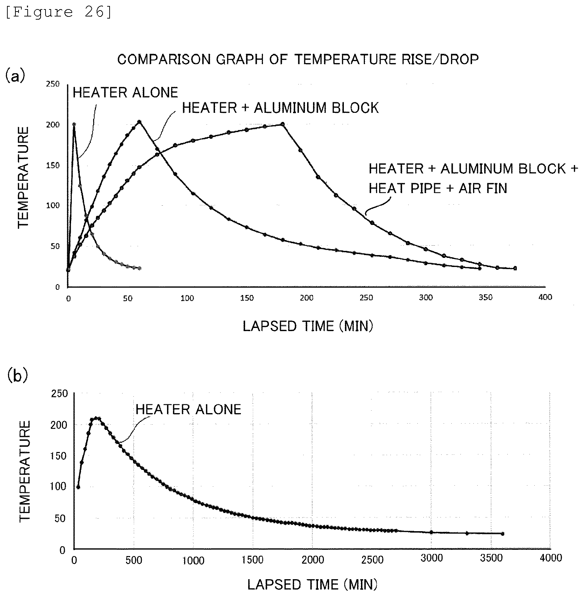

The obtained result of the time-based temperature change for each sample is shown in Figure 26(a). From the obtained result, in the sample formed of the heat generating body only, a steep temperature rise was confirmed, and a steep temperature drop was confirmed even when power source supply was stopped. In contrast, in the sample formed of the heat generating body and the aluminum block, a moderate temperature rise was confirmed and a moderate temperature drop was confirmed even when power source supply was stopped. Therefore, the warming effect based on the latent heat property of the aluminum block was confirmed. In the sample formed of the heat generating body, the aluminum block, the heat pipes, and the air fins, a moderate temperature rise was confirmed, and a slightly moderate temperature drop was confirmed even when power source supply was stopped. Therefore, due to the heat dissipation effects of the heat pipes and the air fins, the moderate temperature rise extending for a long time was confirmed, and the power-saving and high-quality heating performance was confirmed.

### Reference Signs List

- 1: container
- 1a: inner-side insulating portion
- 1b: heat conducting material
- 1c: outer-side insulating portion
- 2: opposed electrode
- 2a: first electrode
- 2b: second electrode
- 3: heat generating body
- 3a: silicon powder
- 3b: carbon powder
- 4: elastic body
- 5: incineration ash powder and/or mineral powder
- 4a: first elastic body
- 4b: second elastic body
- 10: heat generating means
- 20: thermoelectric means
- 21: opposing surface
- 22: rear surface
- 23: metal piece
- 23a: one end
- 23b: other end
- 30: heat storing means
- 40: cooling means
- 41: heat sink
- 50: heat pipe
- 60: heat storing part
- 61: housing portion
- 61a: opening portion
- 61b: through hole
- 62: holding portion
- 62a: opening portion
- 62b: through hole
- 70: fin
- 70a: air fin
- 80: housing container
- 81: heat pipe accommodating portion
- 82: fin
- 83: drain hole
- 100: external power
- 100a: AC-based power
- 100b: DC-based power
- 100c: power control
- 101: turbine
- 102: power generator
- 103: cooling fan
- 104: thermosensor switch
- 200: natural energy
- 300: commercial power

## Claims

1. A heat generating device **characterized by** comprising:
a hollow container an inside of which is electrically insulated;
a pair of opposed electrodes which are housed in the container and which are separately opposed to each other; and
a heat generating body which is housed between the opposed electrodes in the container and contains silicon powder and carbon powder in a mixed state, wherein
the heat generating body has a density of 0.85 g/cm³ to 1.30 g/cm³.

2. The heat generating device according to claim 1, **characterized in that**
the density of the heat generating body is smaller when an average particle diameter and/or total weight of the carbon powder contained in the heat generating body is larger.

3. The heat generating device according to claim 1 or 2, **characterized in that**
the heat generating body contains ferric oxide and/or aluminum oxide in a powder state.

4. The heat generating device according to any one of claims 1 to 3, **characterized in that**
the heat generating body contains incineration ash and/or mineral in a powder state.

5. A power generating apparatus **characterized by** comprising:
heat generating means which is formed of the heat generating device according to any one of claims 1 to 4 and which generates heat upon supply of external power from an outside to the opposed electrodes; and
thermoelectric means which is disposed so as to be close to the heat generating means, of which an opposing surface side opposed to the heat generating means is heated, of which a rear surface side is cooled, and which converts a temperature difference between the opposing surface side and the rear surface side into electric energy.

6. The power generating apparatus according to claim 5, **characterized in that**
the thermoelectric means is formed of a Seebeck element or a Thomson element.

7. The power generating apparatus according to claim 5 or 6, **characterized in that**
the heat generating means is formed into a cylindrical body, and the thermoelectric means surrounds the heat generating means.

8. The power generating apparatus according to any one of claims 5 to 7, **characterized by** further comprising
heat storing means which is formed so as to be disposed between the heat generating means and the thermoelectric means and which stores heat generated by heat generation performed by the heat generating means.

9. The power generating apparatus according to any one of claims 5 to 8, **characterized by** further comprising
cooling means which is disposed so as to be close to a rear surface side of the thermoelectric means and which cools the rear surface of the thermoelectric means.

10. The power generating apparatus according to any one of claims 5 to 9, **characterized in that**
the external power is supplied by power derived from natural energy.

11. The power generating apparatus according to claim 9 or 10, **characterized in that**
the cooling means is formed from a fluid having cooling performance.

12. The power generating apparatus according to claim 11, **characterized in that**
the external power is supplied by power derived from natural energy based on dynamic energy of a fluid, and
the cooling means cools the rear surface of the thermoelectric means by using static energy of the fluid.

13. A heating apparatus **characterized by** comprising:
heat generating means which is formed of the heat generating device according to any one of claims 1 to 4, and which generates heat upon supply of external power from an outside to the opposed electrodes;
a heat pipe having a longitudinal shape;
a heat storing part which is made from a metal ingot, and in which a housing portion formed of a through hole in close contact with at least a longitudinal surface of the heat generating means is formed in the metal ingot, and holding portions being disposed at symmetrical positions around an arrangement position of the housing portion and being formed of through holes holding the heat pipe while being in close contact with a longitudinal surface of the heat pipe is formed in the metal ingot; and
control means which controls heat generation start and heat generation stop of the heat generating means such that thermal energy stored in the heat storing part does not become lower than energy dissipated by the heat pipe.

14. The heating apparatus according to claim 13, **characterized in that**
the metal ingot is made from an aluminum alloy.

15. The heating apparatus according to claim 13 or 14, **characterized in that**
the heat generating means is formed such that the housing portion and the holding portions are each equally divided into two.

16. A warming apparatus **characterized by** comprising:
the heating apparatus according to any one of claims 13 to 15; and
a housing container in which a heat pipe accommodating portion accommodating the heat pipe of the heating apparatus is provided, and which airtightly or non-airtightly houses a medium made from a liquid or gas, wherein
the medium in the housing container is warmed or vaporized.

17. The heating apparatus according to claim 16, **characterized by** being covered with a thermal insulating material.
